(19) Europäisches Patentamt European Patent Office Office européen des brevets

(11) **EP 3 729 520 B1**

(12) **EUROPÄISCHE PATENTSCHRIFT**

(45) Veröffentlichungstag und Bekanntmachung des Hinweises auf die Patenterteilung:
**24.09.2025 Patentblatt 2025/39**

(21) Anmeldenummer: **18825966.7**

(22) Anmeldetag: **17.12.2018**

(51) Internationale Patentklassifikation (IPC):
***H10H 20/851*** *(2025.01)*

(52) Gemeinsame Patentklassifikation (CPC):
**H10H 20/8512; C09K 11/02; C09K 11/77342; C09K 11/77348; H10H 20/851; H10H 20/8513**

(86) Internationale Anmeldenummer:
**PCT/EP2018/085120**

(87) Internationale Veröffentlichungsnummer:
**WO 2019/121455 (27.06.2019 Gazette 2019/26)**

(54) **LICHTKONVERTIERENDES MATERIAL**

LIGHT-CONVERTING MATERIAL

MATERIAU DE CONVERSION DE LUMIÈRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.12.2017 EP 17208177**

(43) Veröffentlichungstag der Anmeldung:
**28.10.2020 Patentblatt 2020/44**

(73) Patentinhaber: **LITEC-Vermögensverwaltungsgesellschaft mbH 17489 Greifswald (DE)**

(72) Erfinder:
• **HEIDEN, Eric 17489 Greifswald (DE)**
• **RAPPHAHN, Mathias 17489 Greifswald (DE)**

(74) Vertreter: **Engel, Christoph Klaus PATENTSCHUTZengel Marktplatz 6 98527 Suhl (DE)**

(56) Entgegenhaltungen:
**US-A1- 2005 135 079    US-A1- 2017 153 382**

• **JAN ZIEGLER ET AL: "Silica-Coated InP/ZnS Nanocrystals as Converter Material in White LEDs", ADVANCED MATERIALS, WILEY-VCH GERMANY, DE, vol. 20, no. 21, 3 November 2008 (2008-11-03), pages 4068 - 4073, XP002639985, ISSN: 0935-9648, [retrieved on 20081013], DOI: 10.1002/ADMA.200800724**

**Beschreibung**

Gegenstand der Erfindung

Die vorliegende Erfindung betrifft ein lichtkonvertierendes Material, das ein Lumineszenzmaterial mit Halbleiter-Nanopartikeln (Quantenmaterialien), enthält, wobei sich die Halbleiter-Nanopartikel auf der Oberfläche des Lumineszenzmaterials befinden und die Emission der Halbleiter-Nanopartikel im Bereich der Emission des Lumineszenzmaterials liegt. Ferner betrifft die Erfindung ein Verfahren zur Herstellung des lichtkonvertierenden Materials sowie dessen Verwendung als Konversionsmaterial in einer Lichtquelle zur teilweisen oder vollständigen Konversion von Licht einer Primärlichtquelle. Das Lumineszenzmaterial kann ein Downconverter oder ein Upconverter sein. Im Falle eines Downconverters ist das Licht der Primärlichtquelle kurzwelliger und energiereicher als das emitierte Licht, zum Beispiel kann ultraviolettes und/oder blaues Licht in Licht mit einer größeren Wellenlänge konvertiert werden. Im Falle eines Upconverters ist das Licht der Primärlichtquelle langwelliger und energieärmer als das emitierte Licht, zum Beispiel können mehrere infrarote Photonen in ein Photon mit einer kleineren Wellenlänge konvertiert werden. Ein weiterer Gegenstand der vorliegenden Erfindung betrifft eine lichtkonvertierende Mischung, eine Lichtquelle, ein Verfahren zur Herstellung der Lichtquelle sowie eine Beleuchtungseinheit, die das erfindungsgemäße lichtkonvertierende Material enthält.

Hintergrund der Erfindung

Rund 20% des inländischen Energieverbrauchs entfällt auf die Erzeugung von Licht. Herkömmliche Glühlampen sind ineffizient und die effizientesten Leuchtstofflampen enthalten bis zu 10 mg Quecksilber. Festkörperbeleuchtungseinrichtungen, wie beispielsweise Leuchtdioden (LEDs), sind eine vielversprechende Alternative, da sie einen besseren Wirkungsgrad bei der Umwandlung von elektrischer Energie in Licht (Energieeffizienz), eine längere Lebensdauer und eine höhere mechanische Stabilität als herkömmliche Lichtquellen aufweisen. LEDs sind in vielfältigen Anwendungen verwendbar, darunter Anzeigen, Kfz- und Schilderbeleuchtung und Wohnungs- und Straßenbeleuchtung. Eine LED kann in Abhängigkeit von der zu ihrer Herstellung verwendeten anorganischen Halbleiterverbindung monochromatisches Licht in unterschiedlichen Bereichen des Spektrums emittieren. "Weißes" Licht, das für einen sehr großen Teil der Beleuchtungsindustrie erforderlich ist, lässt sich mit einer herkömmlichen LED jedoch nicht erzeugen. Derzeitige Lösungen für die Erzeugung von weißem Licht beinhalten entweder die Verwendung von drei oder mehr LEDs mit verschiedenen Farben (z.B. rot, grün und blau oder "RGB") oder die Verwendung einer Farbkonversionsschicht aus einem herkömmlichen Leuchtstoffmaterial (z.B. YAG:Ce) zur Erzeugung weißen Lichtes aus einer ultravioletten (UV) oder blauen Emission einer LED. So wird blaues Licht in Licht mit einer längeren Wellenlänge umgewandelt und die Kombination aus blauem und gelbem Licht wird von dem menschlichen Auge als weißes Licht wahrgenommen. Derartiges weißes Licht ist jedoch fast immer nicht ideal und hat in vielen Fällen unerwünschte oder unangenehme Eigenschaften, die Verbesserung oder Korrektur erfordern können. Der einfachere Aufbau von Konversions-LEDs richtet sich nach dem Massenmarkt von Beleuchtungseinrichtungen. Derzeit sind diese LED-Lampen noch deutlich teurer als herkömmliche Glühlampen und die meisten Fluoreszenzlampen und die im Handel erhältlichen weißen LEDs geben ein bläuliches, kaltweißes Licht mit schlechten Farbwiedergabeeigenschaften ab. Diese als schlecht wahrgenommene Qualität des weißen Lichts stammt von dem gelben Konversionsleuchtstoffmaterial YAG:Ce aufgrund der fehlenden Emission im grünen und roten Teil des Spektrums.
Für Anzeigen ist es wichtig, über drei oder mehr Grundfarben mit einer engen spektralen Halbwertsbreite (FWHM) zu verfügen, die man mit LEDs erhält (typische FWHM < 30 nm). Damit lässt sich ein großer Farbraum abdecken. "Farbraum" wird normalerweise als der Bereich der Farbarten definiert, der durch Mischen von drei Farben erhältlich ist. Die Lösung, drei oder mehr verschiedenfarbige LEDs zu verwenden, ist jedoch für viele Anwendungen zu kostspielig und aufwendig. Es ist daher wünschenswert, über eine Lichtquelle zu verfügen, die mit einer einzigen LED eine große Farbraumabdeckung ermöglicht, was durch schmalbandig emittierende Konversionsmaterialien realisiert werden kann. Ein Verfahren zur Bereitstellung von LEDs für eine Lichtquelle mit breitem Spektrum nutzt Leuchtstoffe, die das kurzwellige LED-Licht in Licht mit einer längeren Wellenlänge umwandeln. Beispielsweise kann ein Leuchtstoff, der Licht über einen breiten Bereich von grünen Wellenlängen emittiert, mit blauem Licht von einer LED angeregt werden, die ein schmales blaues Spektrum erzeugt. Das durch den Leuchtstoff erzeugte grüne Licht wird dann als eine Komponente der weißen Lichtquelle verwendet. Durch Kombinieren mehrerer Leuchtstoffe kann man im Prinzip eine weiße Lichtquelle mit breitem Spektrum schaffen, vorausgesetzt die Effizienzen der Leuchtstoffe bei der Lichtumwandlung sind ausreichend hoch. Dieses würde zu verbesserten Farbwiedergabeeigenschaften führen. Weitere Einzelheiten finden sich in "Status and prospects for phosphor-based white LED Packaging", Z. Liu et al., Xiaobing Front. Optoelectron. China 2009, 2(2): 119-140.
Leider verfügt jedoch ein Lichtdesigner nicht über einen beliebigen Satz an Leuchtstoffen, aus denen er wählen kann. Es gibt nur eine begrenzte Anzahl von herkömmlichen, in LEDs einsetzbaren Leuchtstoffen, die Seltenerdelemente enthalten und die ausreichende Effizienzen bei der Lichtumwandlung aufweisen. Das Emissionsspektrum dieser Leuchtstoffe lässt sich nicht ohne weiteres ändern. Außerdem sind die Spektren insoweit weniger ideal, da das als Funktion der Wellenlänge emittierte Licht nicht konstant ist. Selbst durch Kombination von mehreren Leuchtstoffen erhält man daher keine optimale weiße Lichtquelle. Zusätzlich emittieren aktuell verwendete rote Leuchtstoffe Licht bis tief in den langwelligen roten Spektralbereich, was die Helligkeit derartiger LED und somit deren Effizienz zusätzlich senkt.

Die US-Patente US 7,102,152 B2, US 7,495,383 B2 und US 7,318,651 B2 sowie die US-Patentanmeldung US 2013/0341590 A1 offenbaren Vorrichtungen und Verfahren zur Emission von Licht, wobei sowohl Halbleiter-Nanopartikel in Form von Quantenpunkten (quantum dots - QDs) als auch Nichtquanten-Fluoreszenzmaterialien genutzt werden, um mindestens einen Teil des ursprünglichen von einer Lichtquelle der Vorrichtung emittierten Lichts in Licht mit längerer Wellenlänge umzuwandeln. QDs besitzen eine hohe Quantenausbeute und sie weisen ein schmales Emissionsspektrum mit einer zentralen Emissionswellenlänge, die über die Größe einstellbar ist, auf.

In der WO 2017/004145 A1 werden stabilisierte QD-Strukturen beschrieben, die sich für die Verwendung in einer LED eignen. Eine Kombination von sowohl QDs als auch herkömmlichen Leuchtstoffen kann die Lichtqualität verbessern. QD-Zusätze können Verbesserungen bringen, haben aber den Nachteil einer hohen Eigenabsorption, d.h. sie absorbieren Licht, das emittiert wird, wenn sie selbst angeregt sind. Hierdurch wird die Gesamtenergieeffizienz der Lichtumwandlung reduziert. Zudem reabsorbieren QDs als auch kommerziell erhältliche Rotemitter ebenfalls die grüne Leuchtstoffemission, was zusätzlich zu einer Abnahme der Energieeffizienz und darüber hinaus zu einer Verschiebung des Emissionsspektrums führt, wodurch eine zielgerichtete Farbplanung erschwert wird. Darüber hinaus kann es bei der Verwendung von QD-Materialien und Leuchtstoffen bei der Herstellung der LED zu einer Entmischung kommen, wodurch eine homogene Verteilung der lichtkonvertierenden Materialien nicht mehr gewährleistet ist. Eine verminderte Energieeffizienz sowie eine unzureichende Kontrolle der gewünschten Farbwiedergabe sind die Folge.

Bei einigen Anwendungen sind Cluster mit dicht gepackten QDs erwünscht. Solche dicht gepackten QD-Cluster zeigen ein Phänomen, das unter dem Namen Fluoreszenz-Resonanzenergietransfer (FRET) bekannt ist, siehe z.B. Joseph R. Lakowicz, "Principles of Fluorescence Spectroscopy", 2. Auflage, Kluwer Academic / Plenum Publishers, New York, 1999, S. 367-443. FRET tritt im Verhältnis zwischen einem Donor-QD, der mit einer kürzeren (z.B. blaueren) Wellenlänge emittiert, zu einem Akzeptor-QD, der in direkter Nachbarschaft angeordnet ist und mit längerer Wellenlänge emittiert, auf. Es findet eine Dipol-Dipol-Wechselwirkung zwischen dem Dipolmoment des Donoremissionsübergangs und dem Dipolmoment des Akzeptorabsorptionsübergangs statt. Die Effizienz des FRET-Prozesses hängt von der spektralen Überlappung zwischen der Absorption des Donors und der Emission des Akzeptors ab. Der FRET-Abstand zwischen Quantenpunkten liegt typischerweise bei 10 nm oder weniger. Die Effizienz des FRET-Effekts ist sehr stark abhängig vom Abstand. FRET führt zu einer Farbänderung (Rotverschiebung) und zu Effizienzverlusten bei der Lichtumwandlung. Aus diesem Grund wurden in früheren Arbeiten Anstrengungen unternommen, die Clusterbildung von QDs in lichtkonvertierenden Materialien zu vermeiden.

Halbleiter-Nanopartikel sind eine Klasse von Nanomaterialien, deren physikalische Eigenschaften durch Einstellen der Teilchengröße, Zusammensetzung und Form über einen breiten Bereich hinweg eingestellt werden können. Insbesondere die Fluoreszenzemission zählt zu den Eigenschaften dieser Klasse, die von der Teilchengröße abhängig sind. Die Einstellbarkeit der Fluoreszenzemission beruht auf dem Quantenbegrenzungseffekt, wonach eine Verringerung der Teilchengröße zu einem "Teilchen im Kasten"-Verhalten führt, was zu einer Blauverschiebung der Bandlückenenergie und somit zur Lichtemission führt. So kann beispielsweise die Emission von CdSe-Nanopartikeln von 660 nm für Teilchen mit einem Durchmesser von - 6,5 nm auf 500 nm für Teilchen mit einem Durchmesser von ~ 2 nm eingestellt werden. Ein ähnliches Verhalten kann für andere Halbleiter-Nanopartikel erzielt werden, was dazu führt, dass ein breiter Spektralbereich vom ultravioletten (UV) Bereich (bei Verwendung von beispielsweise ZnSe oder CdS) über den sichtbaren (VIS) Bereich (bei Verwendung von beispielsweise CdSe oder InP) bis in den nahen Infrarot (NIR) Bereich (bei Verwendung von beispielsweise InAs) abgedeckt werden kann. Eine Änderung der Form der Nanopartikel ist bereits für mehrere Halbleitersysteme gezeigt worden, wobei insbesondere die Stäbchenform (rod shape) von Bedeutung ist. Nanostäbchen haben Eigenschaften, die von den Eigenschaften kugelförmiger Nanopartikel abweichen. Beispielsweise zeigen sie eine Emission, die entlang der Längsachse des Stäbchens polarisiert ist, während kugelförmige Nanopartikel eine unpolarisierte Emission aufweisen. Eine weitere attraktive Eigenschaft von kolloidalen Halbleiter-Nanopartikeln ist deren chemische Zugänglichkeit, die eine Verarbeitbarkeit dieser Materialien in unterschiedlicher Weise gestattet. Die Halbleiter-Nanopartikel können aus Lösung durch Spin-Coating oder Sprühbeschichtung in Form von dünnen Schichten aufgetragen werden oder in Kunststoffen eingebettet werden. Jan Ziegler et al. beschreiben in "Silica-Coated InP/ZnS Nanocrystals as Converter Material in White LEDs", Advanced Materials, Bd. 20, Nr. 21, 13. Oktober 2008, Seite 4068-4073, die Herstellung von Weiß-LEDs mit dem Zusatz einer Silicon-Verbundschicht, die ein lichtemittierendes Konversionsmaterial auf einem Hochleistungs-Blau-LED-Chip enthält.

Die Verwendung von Halbleiter-Nanopartikeln in LED-Anwendungen wurde unter anderem in US 2015/0014728 A1 beschrieben, die ein Leuchtstoff-Matrix-Verbundpulver betrifft, das in einer LED verwendet werden kann. Das Leuchtstoff-Matrix-Verbundpulver enthält eine Matrix und mehrere Leuchtstoffe oder Quantenpunkte mit einer Größe von 100 nm oder weniger, die in der Matrix dispergiert sind, wobei die Größe des Verbundpulvers 20 µm oder mehr beträgt und es eine bestimmte Oberflächenrauhigkeit aufweist. Das beschriebene Verbundpulver erfordert bereits bei seiner Herstellung eine genaue Einstellung der Mengenverhältnisse der Leuchtstoffe und Quantenpunkte, um das gewünschte Emissionsverhalten zu erzielen. Eine nachträgliche Anpassung der Mengenverhältnisse ist hingegen nicht möglich, was zu einer eingeschränkten Flexibilität in der Anwendbarkeit des Verbundpulvers bei der Herstellung von LEDs führt. Darüber hinaus hängt die Effizienz der Energiekonversion in starkem Maße von der Art und Menge der in der Matrix dispergierten Leuchtstoffmaterialien ab. Insbesondere, wenn die Menge der Leuchtstoffe und/oder der Quantenpunkte hoch ist, wird es schwierig, das Material zu sintern. Zudem steigt die Porosität an, was eine effiziente Bestrahlung mit Anregungslicht erschwert und die mechanische Festigkeit des Materials beeinträchtigt. Wenn jedoch die Menge der in der Matrix dispergierten Leuchtstoffmaterialien zu gering ist, wird es schwierig, eine ausreichende Lichtkonversion zu erzielen.

Angesichts der zahlreichen Mängel der bekannten oben genannten Lichtumwandlungsmaterialien, darunter die bekannte Kombinationen von QDs mit herkömmlichen Leuchtstoffen (Konversionsleuchtstoffen), besteht ein Bedarf an Halbleiter-Nanopartikel-Materialien und Zusammensetzungen, die solche Materialien mit herkömmlichen Leuchtstoffen enthalten, die keine derartigen Mängel aufweisen. Insbesondere besteht ein Bedarf an Konversionsmaterialien mit geringer bis vernachlässigbarer Reabsorption und mit geringer Eigenabsorption, was zu einem höheren Wirkungsgrad bei der Lichtkonversion und zu einer verbesserten Steuerbarkeit des Farbraumes führt.

Es wäre daher wünschenswert, lichtkonvertierende Materialien auf der Basis von Halbleiter-Nanopartikeln zur Verfügung zu haben, die sich durch eine geringe Reabsorption und Eigenabsorption auszeichnen und somit die Energieeffizienz einer LED erhöhen. Ferner wäre es wünschenswert, lichtkonvertierende Materialien auf der Basis von Halbleiter-Nanopartikeln zur Verfügung zu haben, die sich durch eine verbesserte Mischbarkeit mit herkömmlichen Leuchtstoffen auszeichnen, so dass die oben beschriebenen Nachteile (z.B. verminderte Energieeffizienz und unzureichende Kontrolle der Farbwiedergabe), die sich aufgrund von Entmischungseffekten während der LED-Herstellung ergeben, vermieden werden.

Der Einsatz von Quantenmaterialien ohne eine zusätzliche Anregung, wie sie in der vorliegenden Erfindung vorgesehen ist, erfordert einen hohen Materialeinsatz, um das gewünschte Emissionsspektrum zu realisieren. Dies führt zu negativen Effekten, wie dem bereits beschriebenen FRET sowie erhöhte Effizienzverluste durch Streuung und Reflexion des Lichts an den Partikeln im Silikon. Des Weiteren ist aufgrund der Toxizität bei Verwendung von Cd-haltigen Halbleiter-Nanopartikeln eine Reduzierung der Beladung wichtig.

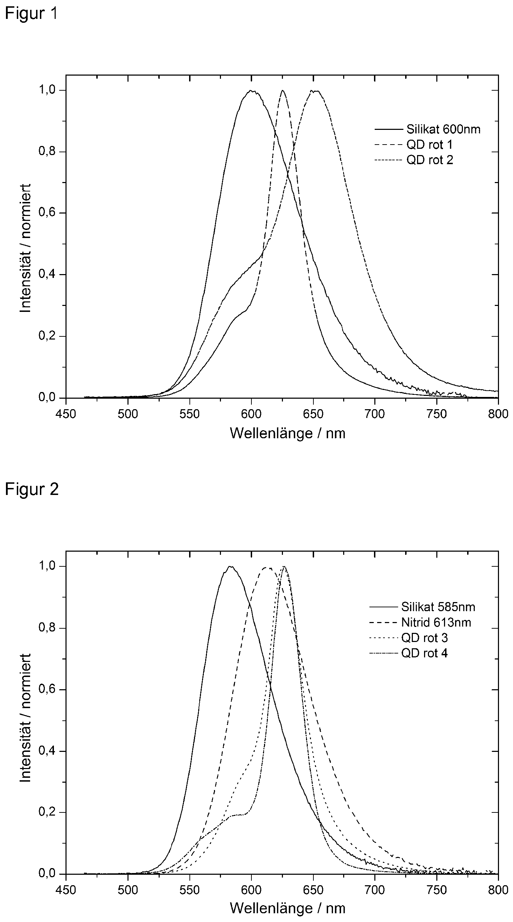

Der Artikel von Ziegler, J. et al.: "Silica-Coated InP/ZnS Nanocrystals as Converter Material in White LEDs" in Advanced Materials, Wiley-VCH Germany, Band 20, Nr. 21, 2008, Seiten 4068 bis 4073 zeigt eine Lösung zur Korrektur des Emissionsspektrums des Leuchtstoffes YAG:Ce durch Zusatz von rot-emittierenden InP-basierten Nanokristallen und von einem grün-emittierenden Konversionsleuchtstoff $Sr_{0,94}Al_2O_4:Eu_{0,06}$. Fig. 1B dieses Artikels zeigt ein Spektrum mit einem Maximum bei 605 nm resultierend aus der Emission der rot-emittierenden Nanokristalle und mit einem Maximum bei 545 nm resultierend aus der Emission des grün-emittierenden Konversionsleuchtstoffes $Sr_{0,94}Al_2O_4:Eu_{0,06}$. Das Maximum bei 545 nm ergibt sich aus Überlagerung einer grünen Emission bei etwa 520 nm und einer gelben Emission des YAG/Ce-Konverters bei 565 nm.

Die US 2005/135079 A1 zeigt ein Blitzmodul, welches eine Lichtquelle umfasst, die ein Primärlicht emittiert. Eine erste wellenlängenkonvertierende Deckschicht auf der Lichtquelle dient zur Bereitstellung einer ersten Lichtfarbe. Die erste wellenlängenkonvertierende Deckschicht enthält eine Vielzahl von Quantenpunkten, die in einem Matrixmaterial dispergiert sind. In einer Ausführungsform ist eine zweite wellenlängenkonvertierende Deckschicht aus herkömmlichem Leuchtstoffmaterial ausgebildet, die in einer Matrix dispergiert ist. Die zweite wellenlängenkonvertierende Deckschicht umfasst wellenlängenkonvertierende Materialien, welche eine zweite Strahlung emittieren, die von den Quantenpunkten in der wellenlängenkonvertierenden Beschichtung nicht stark absorbiert wird. Die zweite wellenlängenkonvertierende Deckschicht lädt die Lichtquelle leicht, damit Primärlicht durch die zweite wellenlängenkonvertierende Deckschicht gelangt, um die Quantenpunkte in der ersten wellenlängenkonvertierenden Deckschicht anzuregen.

Aufgabe der Erfindung

Aufgabe der vorliegenden Erfindung ist es daher, ein lichtkonvertierendes Material auf der Basis von Halbleiter-Nanopartikeln bereitzustellen, das die oben beschriebenen Nachteile aus dem Stand der Technik nicht aufweist. Insbesondere ist es eine Aufgabe der vorliegenden Erfindung, ein lichtkonvertierendes Material basierend auf Halbleiter-Nanopartikeln bereitzustellen, das eine verbesserte Mischbarkeit mit herkömmlichen Leuchtstoffen aufweist und dadurch eine effizientere Herstellung von LEDs ermöglicht, da Verluste aufgrund von Entmischungseffekten während des Mischens vermieden werden. Eine weitere Aufgabe der vorliegenden Erfindung ist die Bereitstellung eines lichtkonvertierenden Materials auf der Basis von Halbleiter-Nanopartikeln, das eine gesteigerte Effizienz der LED sowie einen deutlich verringerten Materialverbrauch in der LED ermöglicht. Ferner ist es Aufgabe der vorliegenden Erfindung ein lichtkonvertierendes Material basierend auf Halbleiter-Nanopartikeln bereitzustellen, das sich durch eine leichte Verarbeitbarkeit bei der Herstellung von LEDs auszeichnet und es LED-Herstellern ermöglicht, bereits vorhandene Ausrüstung und Maschinen für die Herstellung von LEDs zu verwenden. Darüber hinaus soll die vorliegende Erfindung ein

lichtkonvertierendes Material auf der Basis von Halbleiter-Nanopartikeln bereitstellen, das eine verbesserte und zielgerichtetere Einstellung der LED-Emission im Vergleich zu herkömmlichen, in Filmen eingesetzten, Halbleiter-Nanopartikeln ermöglicht, was eine flexiblere Verwendung gestattet. Eine weitere Aufgabe der vorliegenden Erfindung ist die Bereitstellung eines lichtkonvertierenden Materials basierend auf Halbleiter-Nanopartikeln, das eine erhöhte Helligkeit der LED ermöglicht und sich darüber hinaus durch eine schmalbandige Emission auszeichnet, wodurch Energieverluste im langwelligen Spektralbereich vermieden werden und eine verbesserte Farbraumabdeckung in Anzeigen ermöglicht wird. Bei Anwendung in Filmen ist es Ziel der vorliegenden Erfindung, den Materialverbrauch zu verringern und somit eine bessere Effizienz zu ermöglichen. Ferner soll das erfindungsgemäße lichtkonvertierende Material mit bekannten Beschichtungsverfahren, die bei der Herstellung von Leuchtstoffen zur Aufbringung von Barriereschichten verwendet werden, beschichtet werden können, wobei eine solche zusätzliche Barriereschicht für das lichtkonvertierende Material nicht zwingend erforderlich ist.

Beschreibung der Erfindung

Überraschenderweise wurde gefunden, dass die oben beschriebenen Aufgaben durch ein lichtkonvertierendes Material gelöst werden, das ein Lumineszenzmaterial und mindestens eine Art von Halbleiter-Nanopartikeln umfasst, die sich auf der Oberfläche des Lumineszenzmaterials befinden. Das Lumineszenzmaterial und die mindestens einer Art von Halbleiter-Nanopartikeln müssen so ausgewählt werden, dass die Emission der Halbleiter-Nanopartikel im Bereich der Emission des Lumineszenzmaterials liegt. Dies bedeutet, dass sowohl die Halbleiter-Nanopartikel als auch das Lumineszenzmaterial Licht ähnlicher Wellenlänge emittieren.

Beispielsweise können die Halbleiter-Nanopartikel und das Lumineszenzmaterial beide im violetten, blauen, cyanen, grünen, gelben, orangen oder roten Spektralbereich emittieren. Möglich ist auch, dass die Halbleiter-Nanopartikel und das Lumineszenzmaterial in benachbarten Spektralbereichen unterschiedlicher Farbe emittieren, wie z.B. im violetten und blauen, blauen und cyanen, cyanen und grünen, grünen und gelben, gelben und orangen oder orangen und roten Spektralbereich.

Ferner wurde überraschenderweise gefunden, dass die Reabsorption der Emission von Lumineszenzmaterialien, die normalerweise zu Verlusten führt, in diesem Fall zu einer Erhöhung der Effizienz führt und einen deutlich geringeren Materialverbrauch ermöglicht, wobei die Vorteile der schmalbandigen Emission der Halbleiter-Nanopartikel erhalten bleiben. Dies gestattet eine effizientere Nutzung des lichtkonvertierenden Materials sowie eine verbesserte Mischbarkeit des lichtkonvertierenden Materials mit herkömmlichen Leuchtstoffen und ermöglicht somit eine wirtschaftlichere Herstellung effizienter LEDs, die sich durch verbesserte Leistungsdaten, wie Energieeffizienz, Helligkeit und Stabilität, auszeichnen.

Somit werden die oben erwähnten Aufgaben durch ein lichtkonvertierendes Material gelöst, das ein Lumineszenzmaterial und Halbleiter-Nanopartikel umfasst, wobei sich die Halbleiter-Nanopartikel auf der Oberfläche des Lumineszenzmaterials befinden und die Emission der Halbleiter-Nanopartikel im Bereich der Emission des Lumineszenzmaterials liegt. Das Lumineszenzmaterial weist idealerweise eine hohe Absorption im Bereich der Wellenlänge der Primärlichtquelle sowie eine effiziente Emission in der Nähe der Absorption des Halbleiter-Nanopartikels auf. Ein Teil der von dem Lumineszenzmaterial emittierten Photonen wird dabei zur zusätzlichen Anregung der Emission des Halbleiter-Nanopartikels genutzt.

Die Erfinder haben herausgefunden, dass Halbleiter-Nanopartikel verbesserte physikalische Eigenschaften aufweisen, wenn sie sich auf der Oberfläche von Lumineszenzmaterialien befinden, was dazu führt, dass sie sich besser für die Kombination mit herkömmlichen Leuchtstoffen oder als Leuchtstoffersatz in Beleuchtungsanwendungen eignen. Insbesondere haben die Erfinder festgestellt, dass die Verwendung des erfindungsgemäßen lichtkonvertierenden Materials in Lichtquellen zu geringeren Eigenabsorptionseffekten der Halbleiter-Nanopartikel bei hoher Absorption der Primärlichtquelle führt, was eine kontrollierte Farbeinstellung und eine hohe Effizienz ermöglicht. Darüber hinaus werden durch das erfindungsgemäße lichtkonvertierende Material der Fluoreszenz-ResonanzenergieTransfer (FRET) sowie die damit verbundenen unerwünschten Konsequenzen unterdrückt. Halbleiter-Nanopartikel weisen üblicherweise eine sehr hohe Photolumineszenz-Eigenabsorption und eine geringe Absorption im gewünschten blauen oder ultravioletten Spektralbereich auf und müssen daher in hohen Konzentrationen eingesetzt werden. Ein lichtkonvertierendes Material der vorliegenden Erfindung zeichnet sich somit durch eine hohe Reabsorption der effizienten Emission des Lumineszenzmaterials und eine verringerte Eigenabsorption aus.

Darüber hinaus wird ein Verfahren zur Herstellung des erfindungsgemäßen lichtkonvertierenden Materials bereitgestellt, das die folgenden Schritte umfasst: (A) Bereitstellen einer Lumineszenzmaterial-Suspension in einem Lösungsmittel; und (B) Zugabe einer Halbleiter-Nanopartikel-Suspension in einem Lösungsmittel.

Die vorliegende Erfindung stellt ferner eine lichtkonvertierende Mischung bereit, die eines oder mehrere der erfindungsgemäßen lichtkonvertierenden Materialien umfasst.

Das erfindungsgemäße lichtkonvertierende Material sowie die erfindungsgemäße lichtkonvertierende Mischung ermöglichen die teilweise oder vollständige Konversion von ultraviolettem und/oder blauem Licht in Licht mit einer größeren Wellenlänge, wie beispielsweise grünes oder rotes Licht.

Darüber hinaus stellt die vorliegende Erfindung eine Lichtquelle bereit, die mindestens eine Primärlichtquelle und mindestens ein erfindungsgemäßes lichtkonvertierendes Material oder mindestens eine erfindungsgemäße lichtkonvertierende Mischung enthält.

Die Lichtquelle der vorliegenden Erfindung kann in einer Beleuchtungseinheit zum Einsatz kommen.

Die vorliegende Erfindung stellt zudem ein Verfahren zur Herstellung der erfindungsgemäßen Lichtquelle bereit, wobei das erfindungsgemäße lichtkonvertierende Material oder die erfindungsgemäße lichtkonvertierende Mischung als Film durch Spin-Coating, Sprühbeschichtung oder in Form eines Films als Laminat auf die Primärlichtquelle oder ein Trägermaterial aufgetragen wird.

Bevorzugte Ausführungsformen der Erfindung werden in den abhängigen Ansprüchen beschrieben.

Beschreibung der Figuren

**Figur 1:** Relative spektrale Energieverteilung der Emission der hergestellten lichtkonvertierenden Materialien aus den Beispielen 1 und 2 sowie des lumineszenten Ausgangsmaterials.

**Figur 2:** Relative spektrale Energieverteilung der Emission der hergestellten lichtkonvertierenden Materialien aus den Beispielen 3 und 4 sowie der lumineszenten Ausgangsmaterialien.

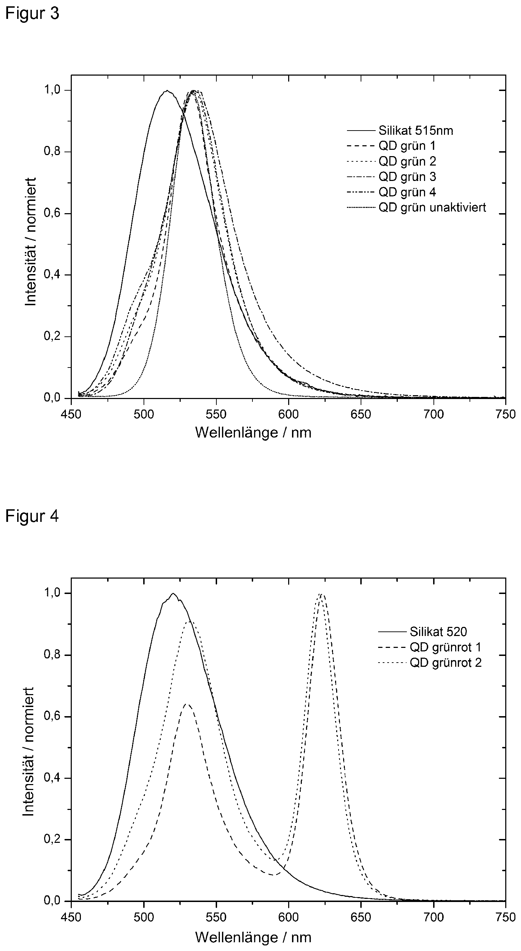

**Figur 3:** Relative spektrale Energieverteilung der Emission der hergestellten lichtkonvertierenden Materialien aus den Beispielen 5 bis 8 sowie eines lumineszenten Ausgangsmaterials und eines lichtkonvertierenden Materials bestehend aus Halbleiter-Nanopartikel und unaktiviertem Orthosilikat, das auf analoge Weise zu Beispiel 6 hergestellt wurde.

**Figur 4:** Relative spektrale Energieverteilung der Emission der hergestellten lichtkonvertierenden Materialien aus den Beispielen 10 und 11 sowie des lumineszenten Ausgangsmaterials.

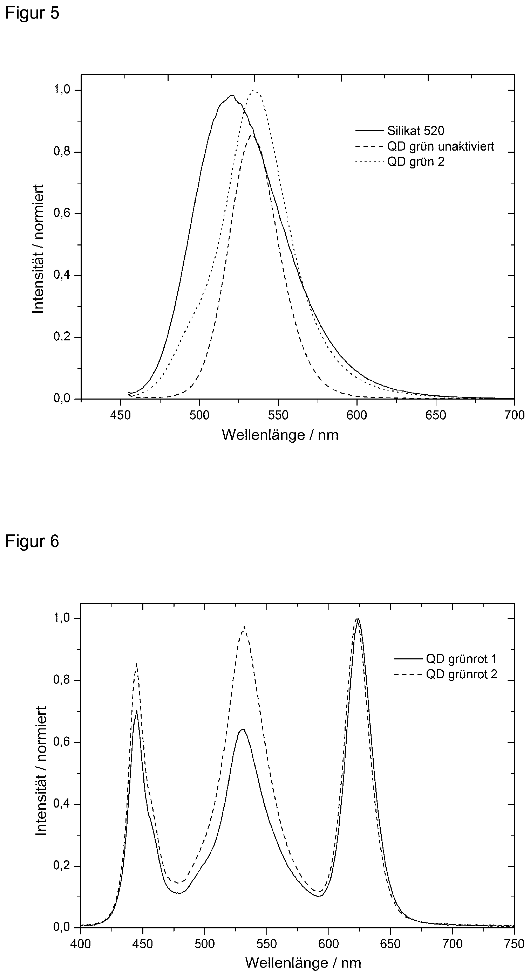

**Figur 5:** Relative spektrale Energieverteilung der Emission (normiert auf das Maximum aller Proben) des hergestellten lichtkonvertierenden Materials aus dem Beispiel 6 sowie des lumineszenten Ausgangsmaterials und eines lichtkonvertierendes Material bestehend aus Halbleiter-Nanopartikel und unaktiviertem Orthosilikat, das auf analoge Weise hergestellt wurde.

**Figur 6:** Emissionsspektren der LEDs, die aus den lichtkonvertierenden Materialien der Beispiele 10 und 11 mit einer blauen LED ($\lambda_{max}$ = 450 nm) hergestellt wurden.

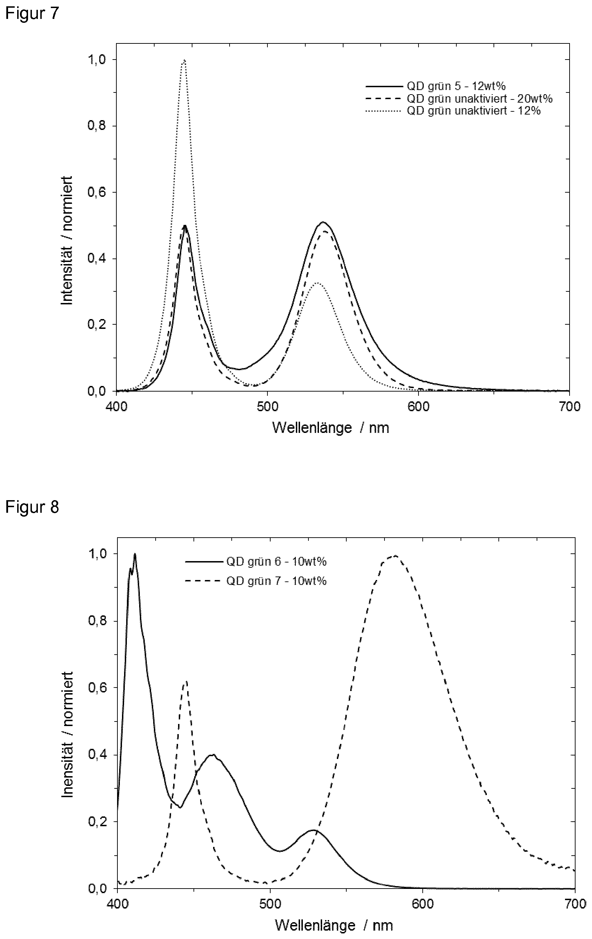

**Figur 7:** Emissionsspektrum der LED, die aus dem lichtkonvertierenden Material aus Beispiel 9 und einer blauen LED ($\lambda_{max}$ = 450 nm) hergestellt wurde (durchgezogene Linie), und Emissionsspektrum einer LED, die aus einem, auf gleiche Weise synthetisierten, lichtkonvertierenden Material auf unaktiviertem Orthosilikat und einer blauen LED ($\lambda_{max}$ = 450 nm) hergestellt wurde (gepunktete Linie). Bei beiden LEDs betrug der Anteil des lichtkonvertierenden Materials im Silicon 12 Gew.-%. Zusätzlich wurde eine LED auf Basis von lichtkonvertierendem Material auf unaktiviertem Orthosilikat am gleichen Farbort der LED mit dem lichtkonvertierenden Material aus Beispiel 9 hergestellt (gestrichelte Linie), was zu einer Konzentrationserhöhung des lichtkonvertierenden Materials im Silicon von 12% auf 20% (+ 67%) führt. Alle Spektren sind auf das höchste Maximum normiert.

**Figur 8:** Emissionsspektren der LEDs, die aus dem lichtkonvertierenden Material aus Beispiel 12 und einer violetten LED ($\lambda_{max}$ = 410 nm) sowie dem lichtkonvertierenden Material aus Beispiel 13 und einer blauen LED ($\lambda_{max}$ = 450 nm) hergestellt wurden. Hier wird veranschaulicht, dass kein zusätzlicher Energietransfer stattfindet, wenn die Emission des Substrats weiter als 50 nm kurzwellig oder weiter als 50 nm langwelliger ist, als die Emission der Halbleiter-Nanopartikel.

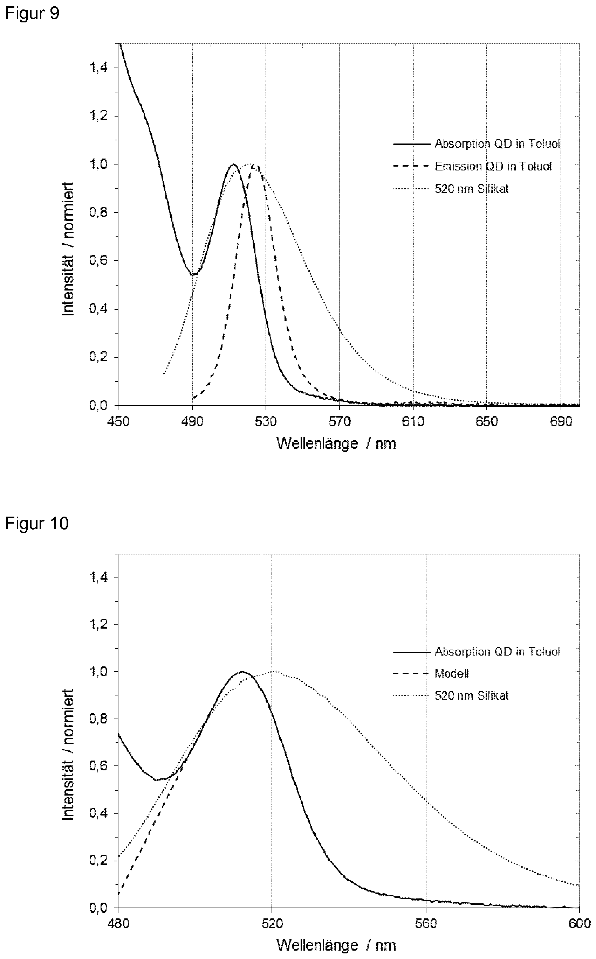

**Figur 9:** Absorptions- und Emissionsspektrum der verdünnten Toluol-Suspension der in Beispiel 5 verwendeten Halbleiter-Nanopartikel sowie eines Silikats mit einer Peak-Emission bei 520 nm. Die Kern-Exziton-Absorptionsbande hat ein Maximum bei 515 nm und das Maximum der Emission befindet sich bei 525 nm.

**Figur 10:** Absorptionsspektrum der verdünnten Toluol-Suspension der in Beispiel 5 verwendeten Halbleiter-Nanopartikel und modellierte Kern-Exziton-Absorptionsbande sowie Emissionsspektrum eines Silikats mit einer Peak-Emission bei 520 nm. Die Kern-Exziton-Absorptionsbande hat ein Maximum bei 515 nm und das Maximum der Emission befindet sich bei 525 nm.

Definitionen

Wie in der vorliegenden Anmeldung verwendet, bezeichnet der Begriff "lichtkonvertierendes Material" eine Kombination aus einem Lumineszenzmaterial und mindestens einer Art von Halbleiter-Nanopartikeln, wobei sich die Halbleiter-Nanopartikel auf der Oberfläche des Lumineszenzmaterials befinden und die Emission der Nanopartikel-Halbleiter im Bereich der Emission des Lumineszenzmaterials liegt. Neben der mindestens einen Art von Halbleiter-Nanopartikeln kann das lichtkonvertierende Material noch weitere Arten von Halbleiter-Nanopartikeln umfassen, deren Emission nicht notwendigerweise im Bereich der Emission des Lumineszenzmaterials liegt. Die weiteren Arten von Halbleiter-Nanopartikel befinden sich vorzugsweise ebenfalls auf der Oberfläche des Lumineszenzmaterials.

Wie in der vorliegenden Anmeldung verwendet, bezeichnet der Begriff "Lumineszenzmaterial" oder "lumineszentes Material" ein in Teilchenform vorliegendes Material, das Licht einer ersten Wellenlänge in Licht einer zweiten Wellenlänge umwandeln kann. Das Lumineszenzmaterial liegt in Form von makroskopischen Teilchen vor, die keine Nanoteilchen sind. Vorzugsweise ist das Lumineszenzmaterial kristallin. Das Lumineszenzmaterial kann ein Upconverter sein, der Licht einer ersten Wellenlänge in Licht einer zweiten Wellenlänge umwandelt, wobei das Licht der zweiten Wellenlänge kürzerwellig als das Licht der ersten Wellenlänge ist, oder ein Downconverter sein, der Licht einer ersten Wellenlänge in Licht einer zweiten Wellenlänge umwandelt, wobei das Licht der zweiten Wellenlänge längerwellig als das Licht der ersten Wellenlänge ist. Typischerweise emittieren Downconverter-Materialien nach Anregung durch kurzwelliges (z. B. ultraviolettes oder blaues) Licht längerwelliges (z. B. grünes oder rotes) Licht. In einer bevorzugten Ausführung ist das Lumineszenzmaterial ein Downconverter. Das Lumineszenzmaterial sollte eine gute Absorption des Lichts der Primärlichtquelle aufweisen.

Mögliche Lumineszenzmaterialien sind Leuchtstoffe oder Konversionsleuchtstoffe, die eine anorganische Matrix und mindestens einen Aktivator, d.h. ein lichtkonvertierendes Zentrum, enthalten. Darüber hinaus kann das Lumineszenzmaterial eine spezifische Eigenabsorption im sichtbaren Bereich besitzen und ist folglich farbig oder farblos. In einer bevorzugten Ausführung ist das Lumineszenzmaterial, wie in der vorliegenden Erfindung verwendet, transparent. Das Lumineszenzmaterial dient in der vorliegenden Erfindung als Trägermaterial für die Halbleiter-Nanopartikel sowie neben der Primärlichtquelle als zusätzliche Anregung für die Emission der Halbleiter-Nanopartikel. Aufgrund der Transparenz des Lumineszenzmaterials kann Licht, das von einer Primärlichtquelle, dem Material selbst, einem anderen Leuchtstoff oder einem anderen lichtkonvertierenden Material emittiert wird, ungehindert und verlustfrei das Material passieren, wodurch die Effizienz der Anwendung des erfindungsgemäßen lichtkonvertierenden Materials in einer LED gesteigert wird. Im Falle eines intransparenten Lumineszenzmaterials sollte dieses zumindest eine hohe Reflektivität besitzen.

Wie in der vorliegenden Anmeldung verwendet, bezeichnen die Begriffe "Leuchtstoff", "Konversionsleuchtstoff" oder "Phosphor", die hier als Synonyme verwendet werden, ein in Teilchenform vorliegendes fluoreszierendes anorganisches Material mit einem oder mehreren emittierenden Zentren. Die emittierenden Zentren entstehen durch Aktivatoren, gewöhnlicherweise Atome oder Ionen eines Seltenerdmetall-Elements, wie beispielsweise La, Ce, Pr, Nd, Pm, Sm, Eu, Gd, Tb, Dy, Ho, Er, Tm, Yb und Lu, und/oder Atome oder Ionen eines Übergangsmetall-Elements, wie beispielsweise Cr, Mn, Fe, Co, Ni, Cu, Ag, Au und Zn, und/oder Atome oder Ionen eines Hauptgruppenmetall-Elements, wie beispielsweise Na, Tl, Sn, Pb, Sb und Bi. Beispiele für Leuchtstoffe bzw. Konversionsleuchtstoffe umfassen Aluminat-basierte Leuchtstoffe wie Granate, Leuchtstoffe auf Silikatbasis, Orthosilikatbasis, Phosphatbasis, Thiogallatbasis, Sulfidbasis und Nitridbasis. Leuchtstoffmaterialien im Sinne der vorliegenden Erfindung weisen keinerlei Quantenbegrenzungseffekte auf. Solche nicht-quantenbegrenzte Leuchtstoffmaterialien können Leuchtstoffteilchen mit oder ohne Siliciumdioxid-Beschichtung sein. Unter einem Leuchtstoff oder Konversionsleuchtstoff im Sinne der vorliegenden Anmeldung wird ein Material verstanden, das in einem bestimmten Wellenlängenbereich des elektromagnetischen Spektrums, vorzugsweise im blauen oder im UV-Spektralbereich, Strahlung absorbiert und in einem anderen Wellenlängenbereich des elektromagnetischen Spektrums, vorzugsweise im violetten, blauen, grünen, gelben, orangen oder roten Spektralbereich Licht emittiert. In diesem Zusammenhang ist auch der Begriff "strahlungsinduzierte Emissionseffizienz" zu verstehen, d. h. der Konversionsleuchtstoff absorbiert Strahlung in einem bestimmten Wellenlängenbereich und emittiert Strahlung in einem anderen Wellenlängenbereich mit einer bestimmten Effizienz. Unter dem Begriff "Verschiebung der Emissionswellenlänge" versteht man, dass ein Konversionsleuchtstoff im Vergleich zu einem anderen oder ähnlichen Konversionsleuchtstoff Licht bei einer anderen Wellenlänge emittiert, das heißt verschoben zu einer kleineren oder größeren Wellenlänge.

Der Begriff "Halbleiter-Nanopartikel" (Quantenmaterial) bezeichnet in der vorliegenden Anmeldung ein Nanoteilchen, das aus einem Halbleitermaterial besteht. Halbleiter-Nanopartikel sind beliebige diskrete Einheiten mit mindestens einer Dimension in Submikrometergröße, die in einigen Ausführungsformen kleiner als 100 nm ist und in einigen anderen Ausführungsformen als größte Abmessung (Länge) eine Größe von weniger als einem Mikrometer besitzt. In einigen anderen Ausführungsformen ist die Abmessung kleiner als 400 nm. Der Halbleiter-Nanopartikel kann jede beliebige symmetrische oder unsymmetrische geometrische Form aufweisen und nicht-einschränkende Beispiele möglicher Formen sind länglich, rund, elliptisch, pyramidal, u.s.w.. Ein spezifisches Beispiel für einen Halbleiter-Nanopartikel ist ein länglicher Nanopartikel, der auch als Nanostäbchen oder Nanostab bezeichnet wird und aus einem halbleitenden Material hergestellt ist. Weitere Halbleiter-Nanostäbchen, die verwendet werden können, sind solche mit einem Metall- oder Metalllegierungsbereich auf einem oder beiden Enden des jeweiligen Nanostäbchens. Beispiele solcher länglichen Halbleiter-Metall-Nanopartikel und deren Herstellung werden in der WO 2005075339 beschrieben, dessen Offenbarung hiermit durch Bezugnahme eingefügt wird. Andere mögliche Halbleiter-Metall-Nanopartikel werden in der WO 2006134599 gezeigt, dessen Offenbarung hiermit durch Bezugnahme eingefügt wird.

Ferner sind Halbleiter-Nanopartikel in einer Kern-Schale-Konfiguration oder einer Kern-Mehrschalen-Konfiguration bekannt. Es handelt sich hierbei um diskrete Halbleiter-Nanopartikel, die durch eine Heterostruktur gekennzeichnet sind, in der ein "Kern" aus einer Materialart mit einer "Schale" aus einem anderen Material bedeckt ist. In einigen Fällen lässt man die Schale auf dem Kern wachsen, der als "Impfkern" dient. Der Kern-Schale-Nanopartikel wird dann auch als "geimpfter" Nanopartikel bezeichnet. Der Ausdruck "Impfkern" oder "Kern" bezieht sich auf das innerste Halbleitermaterial, das in der Heterostruktur enthalten ist. Bekannte Halbleiter-Nanopartikel in Kern-Schale-Konfiguration werden beispielsweise in der EP 2 528 989 B1 gezeigt.

So sind beispielsweise punktförmige Halbleiter-Nanopartikel bekannt, bei denen eine kugelförmige Schale symmetrisch um einen kugelförmigen Kern angeordnet ist (sog. Quantenpunkte in Quantenpunkte). Darüber hinaus sind stäbchenförmige Halbleiter-Nanopartikel bekannt, bei denen ein kugelförmiger Kern asymmetrisch in einer länglichen stäbchenförmigen Schale angeordnet ist (sog. Quantenpunkte in Quantenstäbchen). Der Ausdruck Nanostäbchen bezeichnet ein Nanokristall mit einer stäbchenartigen Form, d.h. ein Nanokristall, der durch verstärktes Wachstum entlang einer ersten ("Längs-")Achse des Kristalls gebildet wird, während die Abmessungen entlang der beiden anderen Achsen sehr klein gehalten werden. Ein Nanostäbchen besitzt einen sehr kleinen Durchmesser (typischerweise weniger als 10 nm) und eine Länge, die im Bereich von etwa 6 nm bis etwa 500 nm liegen kann. Typischerweise weist der Kern eine nahezu kugelförmige Form auf. Es können jedoch auch Kerne mit unterschiedlichen Formen, wie beispielsweise Pseudopyramiden, Würfel-Oktaeder, Stäbchen und andere, verwendet werden. Typische Kerndurchmesser liegen im Bereich von etwa 1 nm bis etwa 20 nm. Bei symmetrischen punktförmigen Halbleiter-Nanopartikel in Kern-Schale-Konfiguration (Quantenpunkte in Quantenpunkte) ist der Partikel-Gesamtdurchmesser $d_2$ üblicherweise viel größer als der Kerndurchmesser $d_1$. Die Größenordnung von $d_2$ im Vergleich zu $d_1$ beeinflusst die optische Absorption des symmetrischen punktförmigen Halbleiter-Nanopartikels in Kern-Schale-Konfiguration.

Bekanntermaßen kann ein Halbleiter-Nanopartikel in Kern-Schale-Konfiguration weitere äußere Schalen umfassen, die bessere optische und chemische Eigenschaften, wie eine höhere Quantenausbeute (QY) und bessere Haltbarkeit bereitstellen können. Der Halbleiter-Nanopartikel weist dann eine Kern-Mehrschalen-Konfiguration auf. Bei einem stäbchenförmigen Halbleiter-Nanopartikel in Kern-Mehrschalen-Konfiguration kann die Länge der ersten Schale im Allgemeinen im Bereich zwischen 10 nm und 200 nm und insbesondere zwischen 15 nm und 160 nm liegen. Die Dicken der ersten Schale in den anderen beiden Dimensionen (radiale Achse der Stäbchenform) kann im Bereich zwischen 1 nm und 10 nm liegen. Die Dicke der weiteren Schalen kann im Allgemeinen im Bereich zwischen 0,3 nm und 20 nm und insbesondere zwischen 0,5 nm und 10 nm liegen.

Andere Ausführungsformen sind z.B. Nanotetrapods (wie in US 8,062,421 B2 beschrieben), die einen Kern, bestehend aus einem ersten Material, und mindestens einen Arm, typischerweise aber vier weitere Arme, bestehend aus einem zweiten Material, umfassen, wobei sich der Kern und die Arme in ihrer Kristallstruktur unterscheiden. Solche Nanotetrapods weisen eine große Stokes-Verschiebung auf.

Der Begriff "Kernmaterial" bezeichnet das Material, das den Kern von Halbleiter-Nanopartikeln in einer Kern-Schale-Konfiguration oder Kern-Mehrschalen-Konfiguration bildet. Das Material kann ein Halbleiter der Gruppen II-VI, III-V, IV-VI oder I-III-VI$_2$ oder eine beliebige Kombination von einem oder mehreren davon sein. Beispielsweise kann das Kernmaterial ausgewählt sein aus der Gruppe bestehend aus CdS, CdSe, CdTe, ZnS, ZnSe, ZnTe, ZnO, GaAs, GaP, GaAs, GaSb, GaN, HgS, HgSe, HgTe, InAs, InP, InSb, AlAs, AlP, AlSb, Cu$_2$S, Cu$_2$Se, CuGaS$_2$, CuGaSe$_2$, CuInS$_2$, CuInSe$_2$, Cu$_2$(InGa)S$_4$, AgInS$_2$, AgInSe$_2$, Cu$_2$(ZnSn)S$_4$, Legierungen davon und Mischungen daraus.

Der Begriff "Schalenmaterial" bezieht sich auf das Halbleitermaterial, aus dem die Schale eines Halbleiter-Nanopartikels mit einer Kern-Schale-Konfiguration oder jede der einzelnen Schalen eines Halbleiter-Nanopartikels mit einer Kern-Mehrschalen-Konfiguration aufgebaut ist. Das Material kann ein Halbleiter der Gruppen II-VI, III-V, IV-VI oder I-III-VI$_2$ oder eine beliebige Kombination von einem oder mehreren davon sein. Beispielsweise kann das Schalenmaterial aus der Gruppe bestehend aus CdS, CdSe, CdTe, ZnS, ZnSe, ZnTe, ZnO, GaAs, GaP, GaAs, GaSb, GaN, HgS, HgSe, HgTe, InAs, InP, InSb, AlAs, AlP, AlSb, Cu$_2$S, Cu$_2$Se, CuGaS$_2$, CuGaSe$_2$, CuInS$_2$, CuInSe$_2$, Cu$_2$(InGa)S$_4$, AgInS$_2$, AgInSe$_2$, Cu$_2$(ZnSn)S$_4$, Legierungen davon und Mischungen daraus ausgewählt sein. Aufgrund der Toxizität von Cd wird bevorzugt ZnS als Schalenmaterial eingesetzt. Dieses hat den Nachteil einer schlechten Absorption im typischen Bereich der blauen LED um 450 nm. Hier führt die zusätzliche Absorption zu einem besonders großen Vorteil in der Endanwendung.

Der Begriff "Ligand" bezieht sich auf eine äußere Oberflächenbeschichtung der Halbleiter-Nanopartikel, die zu einem Passivierungseffekt führt und der Verhinderung einer Agglomeration oder Aggregation der Nanopartikel durch Überwindung der Van-der-Waals-Kräfte dient. Liganden, die allgemein verwendet werden können, sind unter anderem: Phosphine und Phosphinoxide, wie Trioctylphosphinoxid (TOPO), Trioctylphosphin (TOP) oder Tributylphosphin (TBP); Phosphonsäuren, wie Dodecylphosphonsäure (DDPA), Tridecylphosphonsäure (TBPA), Octadecylphosphonsäure (ODPA) oder Hexylphosphonsäure (HPA); Amine, wie Dodecylamin (DDA), Tetradecylamin (TDA), Hexadecylamin (HDA) oder Octadecylamin (ODA); Imine, wie Polyethylenimin (PEI); Thiole, wie Hexadecanthiol oder Hexanthiol; Mercaptocarbonsäuren, wie Mercaptopropionsäure oder Mercaptoundecansäure; und andere Säuren, wie Myristinsäure, Palmitinsäure, Ölsäure, Capronsäure oder Adipinsäure.

Der Begriff "Beschichtungsmaterial" bezeichnet ein Material, das eine Beschichtung auf der Oberfläche der Teilchen des lichtkonvertierenden Materials bildet. Der Begriff "Beschichtung" wird hier verwendet, um eine oder mehrere Schichten eines Materials, das auf einem anderen Material bereitgestellt ist und teilweise oder vollständig die äußere Oberfläche oder die Lösungsmitteln zugängliche Oberfläche des anderen Materials bedeckt, zu beschreiben. Aus dem verwendeten Wortlaut versteht es sich, dass die Beschichtung, die auf jedes einzelne Primärteilchen des lichtkonvertierenden Materials aufgebracht wird, zur Herstellung einer Vielzahl von verschiedenen beschichteten Primärteilchen, die voneinander getrennt sind, führt, anstatt zu einer Vielzahl von Teilchen, die zusammen in demselben Beschichtungsmaterial in Form einer einheitlichen Matrix enthalten oder eingeschlossen sind. Die Primärteilchen des lichtkonvertierenden Materials enthalten typischerweise mehrere Halbleiter-Nanopartikel. Das Material der Beschichtung (Beschichtungsmaterial) kann zumindest teilweise in die innere Struktur des Materials, das beschichtet worden ist, eindringen, sofern die Beschichtung als Barriere noch ausreichend Schutz gegenüber äußeren physikalischen Einflüssen oder den Durchtritt von möglicherweise schädlichen Substanzen, wie z. B. Sauerstoff, Feuchtigkeit und/oder freie Radikale, dient. Hierdurch wird die Stabilität des lichtkonvertierenden Materials erhöht, was zu einer verbesserten Haltbarkeit und Lebensdauer führt. Zusätzlich verleiht in einigen Ausführungsformen das Beschichtungsmaterial dem lichtkonvertierenden Material eine zusätzliche Funktionalität, wie etwa eine verringerte Empfindlichkeit gegenüber Wärme, eine reduzierte Lichtbrechung oder eine verbesserte Anhaftung der lichtkonvertierenden Materialien in Polymeren oder Vergussmaterialien. Ferner können Unebenheiten auf der Oberfläche der Teilchen des lichtkonvertierenden Materials durch den Auftrag eines oder mehrerer Beschichtungsmaterialien geglättet werden. Eine solche Oberflächenglättung ermöglicht eine gute Verarbeitbarkeit des lichtkonvertierenden Materials und reduziert unerwünschte optische Streueffekte des emittierten Lichts an der Oberfläche des Materials, was zu einer gesteigerten Effizienz führt.

Der Begriff "Vergussmaterial" bezieht sich auf ein lichtdurchlässiges Matrixmaterial, das die erfindungsgemäßen lichtkonvertierenden Materialien sowie die erfindungsgemäßen lichtkonvertierenden Mischungen einschließt. Das lichtdurchlässige Matrixmaterial kann ein Silicon, ein Polymer (das aus einem flüssigen oder halbfesten Vorläufermaterial wie einem Monomer gebildet ist), ein Epoxid, ein Glas oder ein Hybrid aus einem Silicon und Epoxid sein. Spezifische, jedoch nicht einschränkende Beispiele der Polymere beinhalten fluorierte Polymere, Polyacrylamid-Polymere, Polyacrylsäure-Polymere, Polyacrylnitril-Polymere, Polyanilin-Polymere, Polybenzophenon-Polymere, Poly(methyl-methacrylat)-Polymere, Silicon-Polymere, Aluminium-Polymere, Polybispheno-Polymere, Polybutadien-Polymere, Polydimethylsiloxan-Polymere, Polyethylen-Polymere, Polyisobutylen-Polymere, Polypropylen-Polymere, Polystyrol-Polymere, Polyvinyl-Polymere, Polyvinylbutyral-Polymere oder Perfluorcyclobutyl-Polymere. Silicone können Gele, wie beispielsweise Dow Corning® OE-6450, Elastomere, wie beispielsweise Dow Corning® OE-6520, Dow Corning® OE-6550, Dow Corning® OE-6630, und Harze, wie beispielsweise Dow Corning® OE-6635, Dow Corning® OE-6665, Nusil LS-6143 und andere Produkte von Nusil, Momentive RTV615, Momentive RTV656 und viele andere Produkte von anderen Herstellern, einschließen. Ferner kann das Vergussmaterial ein (Poly)silazan, wie beispielsweise ein modifiziertes organisches Polysilazan (MOPS) oder ein Perhydropolysilazan (PHPS) sein. Der Anteil des lichtkonvertierenden Materials bzw. der lichtkonvertierenden Mischung, bezogen auf das Vergussmaterial, liegt im Bereich von 1 bis 300 Gew.-%, bevorzugt im Bereich 3-50 Gew.-%.

Der Begriff "Emission" beschreibt im Kontext der vorliegenden Erfindung eine stimulierte Emission oder induzierte Emission eines Photons, die durch ein anderes Photon ausgelöst wird. Ein Emissionsspektrum ist das elektromagnetische Spektrum, das von Atomen, Molekülen oder Materialien ausgestrahlt wird, ohne dass elektromagnetische Strahlung gleicher Frequenz eingestrahlt wird. Während diskrete Energieniveaus ein Linienspektrum hervorrufen, rufen Energiebänder ein kontinuierliches Spektrum hervor. Sowohl Linienspektrum als auch kontinuierliches Spektrum der Emission werden im Kontext der vorliegenden Erfindung auch als "Emissionsbande" bezeichnet. Die Emissionsbande beschreibt somit die in einem Emissionsspektrum gemessene Emissionsintensität in Abhängigkeit von der Wellenlänge. Die Wellenlänge, bei der die Emissionsintensität maximal ist, wird als "Emissionsmaximum" $\lambda_{em,max}$ bezeichnet.

Der Begriff "Absorption" bezeichnet im Kontext der vorliegenden Erfindung allgemein das Aufnehmen einer Welle oder eines Teilchens, wie beispielsweise einer elektromagnetischen Welle oder eines Photons, in einen absorbierenden Stoff bzw. Körper, wodurch dieser in einen Zustand höherer Energie angeregt wird. Bei der Absorption wird die Transmission der Welle oder Strahlung durch einen Stoff oder Körper abgeschwächt. Weitere abschwächende Effekte infolge von Streuung oder Reflexion werden in der Optik gemeinsam mit denen der Absorption unter dem Begriff der Extinktion, auch Absorbanz, zusammengefasst. Beispielsweise erfolgt bei Halbleiter-Nanopartikeln die Absorption allgemein über die beiden folgenden Mechanismen (1) und (2):

(1)     Direkte Anregung des erlaubten Exziton-Übergangs im Kern. In Figur 9 ist dies durch das Absorptionsspektrum im Bereich von ca. 490 bis 550 nm als schmale Bande erkennbar.

(2)     Anregung der Bandlücke in der Schale. Dies ist in Figur 9 durch die in Richtung kleinerer Wellenlängen ansteigende Absorptionsintensität veranschaulicht.

Der Begriff "Anregung" bezeichnet im Kontext der vorliegenden Erfindung die Intensität der Emission, die in Abhängigkeit von der Anregungswellenlänge auftritt.

Mit "Emission" wird der physikalische Prozess bezeichnet, bei dem ein Quantenzustand höherer Energie eines Teilchens durch Emission eines Photons in einen Quantenzustand niedrigerer Energie überführt wird, wodurch Licht entsteht. Die Frequenz des emittierten Lichts ist eine Funktion der Energie des quantenmechanischen Übergangs. Da die Energie erhalten werden muss, ist die Energiedifferenz zwischen den beiden quantenmechanischen Zuständen gleich der Energie des emittierten Photons. Die Energiezustände der quantenmechanischen Übergänge können zu Emissionen von Licht mit einem sehr großen Frequenzbereich führen. Zum Beispiel wird sichtbares Licht durch Kopplung von elektronischen Zuständen in Atomen und Molekülen emittiert. Dann wird das Phänomen Fluoreszenz oder Phosphoreszenz genannt.

Ein "Emissionsspektrum" ist das elektromagnetische Spektrum, das von Atomen, Molekülen oder Materialien ausgestrahlt wird, ohne dass elektromagnetische Strahlung gleicher Frequenz eingestrahlt wird. Das Gegenstück eines Emissionsspektrums bildet das Absorptionsspektrum. Während diskrete Energieniveaus ein Linienspektrum hervorrufen, rufen Energiebänder ein kontinuierliches Spektrum hervor.

Ein "Absorptionsspektrum" ist das elektromagnetische Spektrum eines Materials, das dunkle Spektrallinien enthält. Es entsteht, wenn breitbandiges (weißes) Licht Materie durchstrahlt und Photonen bestimmter Wellenlängen oder Wellenlängenbereiche dabei absorbiert werden. Die absorbierten Photonen fehlen im hindurchtretenden Licht, weshalb das Spektrum bei den betreffenden Wellenlängen schwarz ist. Werden die Photonen absorbiert, indem sie Atome anregen, handelt es sich um scharf definierte Energiebeträge und damit Wellenlängen, und die dunklen Bereiche sind dementsprechend dunkle Linien. In Molekülen liegen dagegen oft viele absorbierbare Energiewerte dicht beieinander und bilden im Spektrum breite dunkle Bereiche, sogenannte Absorptionsbanden. Das beobachtete Absorptionsspektrum ist charakteristisch für die Art der Materie, die die Strahlung durchquert. Sowohl diskrete Absorptionslinien als auch dicht beieinander liegende Absorptionswellenlängen werden im Kontext der vorliegenden Erfindung als Absorptionsbande bezeichnet. Eine Absorptionsbande beschreibt somit die in einem Absorptionsspektrum gemessene Absorptionsintensität in Abhängigkeit von der Wellenlänge.

Ein "Exziton" ist ein gebundenes Elektron-Loch-Paar in einem Isolator oder Halbleiter. Ein Exziton kann sich durch den Kristall bewegen und transportiert dabei seine Anregungsenergie durch diesen hindurch, ohne dass ein Ladungstransport stattfindet, da das Exziton elektrisch neutral ist. Exzitonen habe einen ganzzahligen Spin. Ein Exziton spielt eine große Rolle bei der Absorption von Licht in Halbleitern. Es kann z. B. entstehen, wenn ein Photon in einen Halbleiter eindringt und ein Elektron zum Übergang aus dem Valenzband in das Leitungsband anregt. Das Elektron und das im Valenzband entstandene, entgegengesetzt geladene Loch ziehen sich durch die Coulomb-Kraft gegenseitig an. Exzitonen bieten zusätzliche Energieniveaus für die Absorption von Photonen an. Mit Hilfe des Bohr'schen Atommodells können die Energieniveaus der Entstehung von Exzitonen teilweise für ein Material vorhergesagt werden. Diese Energieniveaus liegen unterhalb der Bandlücke. Außerdem erhöhen Exzitonen die Übergangswahrscheinlichkeit von Elektronen und verstärken eine schon vorhandene Absorption von Photonen im Energiebereich der Bandlücke.

Im Kern der Halbleiter-Nanopartikel ändert sich die Bandlücke wenn die Partikel die gleiche Größe wie der doppelte Exziton-Bohr-Radius unterschreiten und das so genannte Quantenconfinement auftritt. Dabei verschiebt sich die Bandlücke zu höheren Energien bzw. kleineren Wellenlängen. Im Leitungsband und Valenzband entstehen diskrete Energieniveaus, während im makroskopischen Festkörper kontinuierliche Energieniveaus vorhanden sind. Daher absorbiert und emittiert z.B. ein CdSe-Kern mit einer Größe unter 10 nm erst elektromagnetische Strahlung mit einer Wellenlänge unterhalb von ca. 550 nm, während ein makroskopischer Festkörper bereits Strahlung ab ca. 700 nm absorbiert. Da die Schale typischerweise deutlich größer als der Kern ist, entspricht die Bandlücke der des makroskopischen Festkörpers und Leitungsband sowie Valenzband haben kontinuierliche Energieniveaus. Die Bandlücke des Schalenmaterialies liegt üblicherweise bei höherer Energie, als die kleinste Exziton-Absorptionsenergie im Kern. In diesem Fall kann man eine ausgeprägte Absorptionsbande des Exzitonübergangs im Kern, bei kleinerer Energie bzw. bei größerer Wellenlänge beobachten. Die Absorption der Schale beginnt dann bei höherer Energie bzw. kürzerer Wellenlänge. Dies ist auch im Absorptionsspektrum in Figur 9 (durchgezogene Linie) veranschaulicht, in der die Kern-Exzitonabsorption im Bereich 490 bis 550 nm als Bande sichtbar ist, während die Bandlückenabsorption der Schale unterhalb von 450 nm kontinuierlich ansteigt.

Der Exziton-Bohr-Radius $a_b{}^*$ wird nach folgender Formel berechnet:

$$a_b{}^* = \varepsilon_r(m/\mu)a_b$$

wobei $\varepsilon_r$ die größenabhängige Dielektrizitätskonstante, m die Masse, $\mu$ die reduzierte Masse und $a_b$ den Bohr-Radius (0,053 nm) bezeichnet.

Die Wellenlänge, bei der die Kern-Exziton-Absorptionsbande ihr Maximum hat, wird als $\lambda_{ex,max}$ bezeichnet. Dies wird durch das lokale Maximum im Bereich 490 bis 530 nm der Kurve des Absorptionsspektrum in den Figur 9 und 10 (durchgezogene Linie) dargestellt.

Bevorzugte Ausführungsformen der Erfindung

Gegenstand der vorliegenden Erfindung ist, wie oben beschrieben, ein lichtkonvertierendes Material, das ein Lumineszenzmaterial und mindestens eine Art von Halbleiter-Nanopartikeln umfasst, wobei sich die Halbleiter-Nanopartikel auf der Oberfläche des Lumineszenzmaterials befinden und die Emission der Halbleiter-Nanopartikel im Bereich der Emission des Lumineszenzmaterials liegt.

Es ist bevorzugt, dass die Emissionsbande der Halbleiter-Nanopartikel und die Emissionsbande des Lumineszenzmaterials ganz oder teilweise überlappen.

Es ist weiterhin bevorzugt, dass das Emissionsmaximum der Halbleiter-Nanopartikel und das Emissionsmaximum des Lumineszenzmaterials maximal 50 nm auseinander liegen. Es gilt dann die folgende Gleichung (1):

$$0 \text{ nm} \le |\lambda_{em,max}(\text{Halbleiter-Nanopartikel}) - \lambda_{em,max}(\text{Lumineszenzmaterial})| \le 50 \text{ nm} \tag{1}$$

Es ist besonders bevorzugt, dass das Emissionsmaximum der Halbleiter-Nanopartikel und das Emissionsmaximum des Lumineszenzmaterials maximal 30 nm auseinander liegen. Es gilt dann die folgende Gleichung (2):

$$0 \text{ nm} \le |\lambda_{em,max}(\text{Halbleiter-Nanopartikel}) - \lambda_{em,max}(\text{Lumineszenzmaterial})| \le 30 \text{ nm} \tag{2}$$

Es ist weiterhin besonders bevorzugt, dass das Emissionsmaximum der Halbleiter-Nanopartikel und das Emissionsmaximum des Lumineszenzmaterials maximal 20 nm auseinander liegen. Es gilt dann die folgende Gleichung (3):

$$0 \text{ nm} \le |\lambda_{em,max}(\text{Halbleiter-Nanopartikel}) - \lambda_{em,max}(\text{Lumineszenzmaterial})| \le 20 \text{ nm} \tag{3}$$

In einer am stärksten bevorzugten Ausführungsform ist das Emissionsmaximum des Lumineszenzmaterials gegenüber dem Emissionsmaximum der Halbleiter-Nanopartikel um bis zu 20 nm in den kürzerwelligen Spektralbereich verschoben. Es gilt dann die folgende Gleichung (4):

$$0 \text{ nm} \le \lambda_{em,max}(\text{Halbleiter-Nanopartikel}) - \lambda_{em,max}(\text{Lumineszenzmaterial}) \le 20 \text{ nm} \tag{4}$$

Emissionsspektren können für die vorliegende Erfindung mit jedem beliebigen Spektrometer aufgenommen werden, das geeignet ist, die Emissionsintensität in Abhängigkeit von der Wellenlänge zu bestimmen. Das Emissionsmaximum kann mithilfe einer geeigneten Software zur Bearbeitung und Auswertung von Emissionsspektren bestimmt werden. Geeignete Spektrometer sind beispielsweise das USB 2000, HR 4000 oder das QE65 Pro von Ocean Optics.

In einer bevorzugten Ausführungsform werden das Lumineszenzmaterial und die Halbleiter-Nanopartikel so ausgewählt, dass die Anregung der Halbleiter-Nanopartikel im Bereich der Anregung des Lumineszenzmaterials liegt. Dies bedeutet, dass sowohl die Halbleiter-Nanopartikel als auch das Lumineszenzmaterial durch Licht mit ähnlicher Wellenlänge angeregt werden bzw. dieses absorbieren. Beispielsweise können die Halbleiter-Nanopartikel und das Lumineszenzmaterial beide im ultravioletten, violetten, blauen oder cyanen Spektralbereich angeregt werden.

Es ist bevorzugt, dass die Anregungsbande der Halbleiter-Nanopartikel und die Anregungsbande des Lumineszenzmaterials mit der Emissionsbande der Primärlichtquelle ganz oder teilweise überlappen.

In der vorliegenden Erfindung liegt das Maximum der Kern-Exziton-Absorptionsbande der Halbleiter-Nanopartikel und das Emissionsmaximum des Lumineszenzmaterials maximal 50 nm auseinander.

Es gilt dann die folgende Gleichung (5):

$$0 \text{ nm} \le |\lambda_{ex,max}(\text{Halbleiter-Nanopartikel}) - \lambda_{em,max}(\text{Lumineszenzmaterial})| \le 50 \text{ nm} \tag{5}$$

Es ist stärker bevorzugt, dass das Maximum der Kern-Exziton-Absorptionsbande der Halbleiter-Nanopartikel und das Emissionsmaximum des Lumineszenzmaterials maximal 30 nm auseinander liegen. Es gilt dann die folgende Gleichung (6):

$$0 \text{ nm} \leq |\lambda_{ex,max}(\text{Halbleiter-Nanopartikel}) - \lambda_{em,max}(\text{Lumineszenzmaterial})| \leq 30 \text{ nm} \tag{6}$$

In einer am stärksten bevorzugten Ausführungsform liegen das Maximum der Kern-Exziton-Absorptionsbande der Halbleiter-Nanopartikel und das Emissionsmaximum des Lumineszenzmaterials maximal 10 nm auseinander. Es gilt dann die folgende Gleichung (7):

$$0 \text{ nm} \leq |\lambda_{ex,max}(\text{Halbleiter-Nanopartikel}) - \lambda_{em,max}(\text{Lumineszenzmaterial})| \leq 10 \text{ nm} \tag{7}$$

Absorptions- und Emissionsspektren können für die vorliegende Erfindung mit jedem beliebigen Spektrometer aufgenommen werden, das geeignet ist, die Absorptionsintensität bzw. die Emissionsintensität in Abhängigkeit von der Wellenlänge zu bestimmen. Absorptions- und Emissionsmaxima können mithilfe einer geeigneten Software zur Bearbeitung und Auswertung von Spektren bestimmt werden. Dem Fachmann sind geeignete Spektrometer und Software bekannt.

Absorptionsspektren von Halbleiter-Nanopartikeln in Suspension (z.B. Toluol, Ethanol oder Wasser) werden in der vorliegenden Erfindung allgemein wie folgt gemessen: Mithilfe eines UV-VIS-Spektrometers (z.B. UV-2550 von Shimadzu) wird die Absorption in Abhängigkeit von der Wellenlänge im Vergleich zum reinen Lösungsmittel gemessen. Dabei muss darauf geachtet werden, dass die Absorption im untersuchten Wellenlängen-Bereich zwischen 30% und 100 % liegt. Wird dieser Bereich über- oder unterschritten, muss die Suspension entsprechend verdünnt oder aufkonzentriert werden.

Absorptionsspektren von Lumineszenzmaterialien werden in der vorliegenden Erfindung allgemein wie folgt gemessen: Eine in einem Probenhalter präparierte Pulverprobe des Materials wird schrittweise mit monochromatischer elektromagnetischer Strahlung angeregt und die Anzahl emittierter Photonen wird mittels eines Photoelektronenvervielfachers im 90°-Winkel zur Anregungsquelle detektiert.

Emissionsspektren von Halbleiter-Nanopartikeln werden in der vorliegenden Erfindung mit Hilfe von einem Hamamatsu Photonics C9920-02 Messsystem und der vom Hersteller vorgegebenen Prozedur gemessen. Die Absorption der Suspension bei der gewählten Anregungswellenlänge sollte im Bereich von 15% bis 40% liegen. Dies wird durch Einstellung der Konzentration im jeweiligen Lösungsmittel erreicht.

Im Fall einer Bandenemission des Lumineszenzmaterials ist es bevorzugt, dass die Emissionsbande des Lumineszenzmaterials ganz oder teilweise mit der Kern-Exziton-Absorptionsbande der Halbleiter-Nanopartikel überlappt.

Für die Bestimmung der Überlappung der Banden werden die normierten Emissions- bzw. Absorptionsspektren herangezogen, aus denen die sich überlappende Fläche $A_{OL}$ der Emissionsbande des Lumineszenzmaterials und der Kern-Exziton-Absorptionsbande der Halbleiter-Nanopartikel bestimmt wird. Anschließend wird das Verhältnis der sich überlappenden Flächen $A_{OL}$ zur Gesamtfläche der Kern-Exziton-Anregungsbande $A_{ex}$ der Halbleiter-Nanopartikel gebildet: $A_{OL}/A_{ex}$. Die Gesamtfläche $A_{ex}$ wird durch Modellieren der Kern-Exziton-Absorptionsbande erhalten, wie in Figur 10 gezeigt ist.

Es ist bevorzugt, dass die Überlappung $A_{OL}$ zwischen der Emissionsbande des Lumineszenzmaterials und der Kern-Exziton-Absorptionsbande der Halbleiter-Nanopartikel mindestens 50%, bezogen auf die Gesamtfläche der Kern-Exziton-Anregungsbande $A_{ex}$, beträgt. Es gilt dann die folgende Gleichung (8):

$$(8) \qquad A_{OL} / A_{ex} * 100\% > 50\%$$

Es ist in der vorliegenden Erfindung bevorzugt dass die Überlappung mindestens 80% beträgt. Es gilt dann die folgende Gleichung (9):

$$(9) \qquad A_{OL} / A_{ex} * 100\% > 80\%$$

Figur 9 und 10 zeigen ein Beispiel, in dem die Überlappung mindestens 80% beträgt.

Im Fall einer Linienemission des Lumineszenzmaterials ist es bevorzugt, dass die Emissionsbande mit der maximalen Intensität (Emissionsmaximum $\lambda_{em,max}$) des Lumineszenzmaterials und das Maximum der Kern-Exziton-Absorptionsbande ($\lambda_{ex,max}$) der Halbleiter-Nanopartikel maximal 50 nm auseinander liegen. Es gilt dann die Gleichung (5). Hierbei ist es besonders bevorzugt, dass das Emissionsmaximum $\lambda_{em,max}$ des Lumineszenzmaterials und das Maximum der Kern-Exziton-Absorptionsbande $\lambda_{ex,max}$ der Halbleiter-Nanopartikel zwischen 0 und 30 nm auseinander liegen. Es gilt dann die Gleichung (6). Hierbei ist es am stärksten bevorzugt, dass das Maximum der Kern-Exziton-Absorptionsbande $\lambda_{ex,max}$ der Halbleiter-Nanopartikel und das Emissionsmaximum $\lambda_{em,max}$ des Lumineszenzmaterials maximal 10 nm auseinander liegen. Es gilt dann die Gleichung (7). Figur 9 zeigt ein Beispiel, in dem die Bedingungen der Gleichungen (5) bis (9) erfüllt sind.

Das resultierende lichtkonvertierende Material der vorliegenden Erfindung kann als Schüttgut, Pulvermaterial, dickes oder dünnes Schichtmaterial oder selbstragendes Material in Form eines Films vorliegen. Ferner kann es in einem Vergussmaterial eingebettet sein. Das lichtkonvertierende Material kann Zusatzmaterialien, wie beispielsweise Liganden und/oder Beschichtungsmaterialien, umfassen.

Das in dem lichtkonvertierenden Material verwendete Lumineszenzmaterial ist farbig oder farblos und bevorzugt transparent. Licht, das von einer Primärlichtquelle oder von einem anderen Lumineszenzmaterial emittiert wird, kann von dem verwendeten Lumineszenzmaterial absorbiert werden und Licht, das zu den Halbleiter-Nanopartikeln auf der Oberfläche des verwendeten Lumineszenzmaterials gelangt, kann von diesen absorbiert und in Licht mit gleicher oder größerer Wellenlänge konvertiert und emittiert werden, wodurch die Effizienz der LED bei Verwendung des erfindungsgemäßen lichtkonvertierenden Materials steigt.

Alternativ kann im Fall der Verwendung eines transparenten Lumineszenzmaterials das Licht einer Primärlichtquelle oder von einem anderen Lumineszenzmaterial ungehindert und verlustfrei das verwendete Lumineszenzmaterial passieren und zu den Halbleiter-Nanopartikeln auf der Oberfläche gelangen, von denen es absorbiert, in Licht mit längerer Wellenlänge konvertiert und dann emittiert wird, wodurch die Effizienz bei Verwendung des erfindungsgemäßen lichtkonvertierenden Materials in einer LED gesteigert wird.

In der vorliegenden Erfindung dient das Lumineszenzmaterial als Trägermaterial und sorgt zugleich für eine effizientere Anregung der Halbleiter-Nanopartikel, die sich auf der Oberfläche des Lumineszenzmaterials befinden. Die Halbleiter-Nanopartikel können hierbei statistisch oder in einer definierten Anordnung auf der Oberfläche des Lumineszenzmaterials verteilt sein.

In einer bevorzugten Ausführungsform der vorliegenden Erfindung liegt der Gewichtsanteil der Halbleiter-Nanopartikel, die sich auf der Oberfläche des Lumineszenzmaterials befinden, im Bereich von 0,1 bis 5 Gew.-%, bezogen auf das Gesamtgewicht des lichtkonvertierenden Materials.

Das Lumineszenzmaterial ist in der vorliegenden Erfindung hinsichtlich der chemischen Zusammensetzung nicht beschränkt. Geeignete Lumineszenzmaterialien sind beispielsweise anorganische Leuchtstoffe (Phosphore), die Aktivatoren also emittierende Zentren aufweisen. Solche anorganischen Leuchtstoffe sind lumineszent im Sinne der vorliegenden Erfindung, da sie eine spezifische Eigenabsorption zeigen und kurzwelliges Licht konvertieren. Sie eignen sich daher als Trägermaterialien für die Halbleiter-Nanopartikel.

In einer bevorzugten Ausführungsform der vorliegenden Erfindung ist das Lumineszenzmaterial ein anorganischer Leuchtstoff, ausgewählt aus der Gruppe umfassend lumineszente Metalloxide, Silikate und Halosilikate, Phosphate und Halophosphate, Borate, Haloborate und Borosilikate, Aluminate, Gallate und Alumosilikate, Molybdate und Wolframate, Sulfate, Sulfide, Selenide und Telluride, Nitride und Oxynitride, SiAlONe, komplexe Metall-Sauerstoff-Verbindungen, Halogen-Verbindungen und Oxy-Verbindungen, wie vorzugsweise Oxysulfide oder Oxychloride. Die Verbindungen sind typischerweise mit Metallen, ausgewählt aus der Liste bestehend aus Eu, Ce, Mn, Tb, Sm, Cr, Sn, Pb, Sb, Bi, Cu und Ag oder Mischungen davon, aktiviert. Besonders bevorzugte Aktivatoren sind Eu(II), Ce(III), Mn(II), Mn(IV), Eu(III), Tb(III), Sm(III), Cr(III), Sn(II), Pb(II), Sb(III), Bi(III), Cu(I) und Ag(I) sowie Mischungen davon.

Bevorzugte lumineszente komplexe Metall-Sauerstoff-Verbindungen sind lumineszente Antimonate, lumineszente Arsenate, lumineszente Germanate, lumineszente Hafnate, lumineszente Halogermanate, lumineszente Indate, lumineszente Lanthanate, lumineszente Niobate, lumineszente Scandate, lumineszente Stannate, lumineszente Tantalate, lumineszente Titanate, lumineszente Vanadate, lumineszente Halovanadate, lumineszente Phosphovanadate, lumineszente Yttrate und lumineszente Zirconate.

Beispiele lumineszenter Metalloxide umfassen: $M^{2+}O:D$, $M^{3+}_2O_3:D$ und $M^{4+}O_2:D$, worin $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Ga, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; $M^{4+}$ Ti, Zr, Ge, Sn und/oder Th ist; und D ein oder mehrere Aktivatoren, ausgwählt aus der Liste bestehend aus Eu, Ce, Mn, Tb, Sm, Cr, Sn, Pb, Sb, Bi, Cu und Ag, ist.

Bevorzugte Beispiele lumineszenter Metalloxide sind: $Al_2O_3:D$, $CaO:D$, $Ga_2O_3:D$, $La_2O_3:D$, $ThO_2:D$, $Y_2O_3:D$, $ZnO:D$, $(Y,Gd)_2O_3:D$ und $(Zn,Cd)O:D$.

Beispiele lumineszenter Silikate oder Halosilikate umfassen: $M^{2+}SiO_3:D$, $M^{2+}_2SiO_4:D$, $M^{2+}_2(Si,Ge)O_4:D$, $M^{2+}_3SiO_5:D$, $M^{3+}_2SiO_5:D$, $M^{3+}M^+SiO_4:D$, $M^{2+}Si_2O_5:D$, $M^{2+}_2Si_2O_6:D$, $M^{2+}_3Si_2O_7:D$, $M^{2+}_2M^+_2Si_2O_7:D$, $M^{3+}_2Si_2O_7:D$, $M^{2+}_4Si_2O_8:D$, $M^{2+}_2Si_3O_8:D$, $M^{2+}_3M^{3+}_2Si_3O_{12}:D$, $M^+M^{3+}M^{2+}_4Si_4O_{10}:D$, $M^+M^{2+}_4M^{3+}Si_4O_{14}:D$, $M^{2+}_3M^{3+}_2Si_6O_{18}:D$, $M^{3+}SiO_3X:D$, $M^{2+}_3SiO_4X_2:D$, $M^{2+}_5SiO_4X_6:D$, $M^+_2M^{2+}Si_4O_{10}X_2:D$, $M^{2+}_5Si_4O_{10}X_6:D$, $M^+_2SiX_6:D$, $M^{2+}_3SiO_3X_4$ und $M^{2+}_9(SiO_4)_4X_2:D$, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La

und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; X ein oder mehrere Halogene, vorzugsweise F, Cl, Br und/oder I, ist; und D ein oder mehrere Aktivatoren, ausgewählt aus der Liste bestehend aus Eu, Ce, Mn, Tb, Sm, Cr, Sn, Pb, Sb, Bi, Cu und Ag, ist.

Bevorzugte Beispiele lumineszenter Silikate und Halosilikate sind: $Ba_2(Mg,Sr)Si_2O_7$:D, $Ba_2SiO_4$:D, $(Ba,Sr)_2SiO_4$:D, $Ba_5SiO_4Br_6$:D, $BaSi_2O_5$:D, $BaSrMgSi_2O_7$:D, $Be_2SiO_4$:D, $Ca_2MgSi_2O_7$:D, $Ca_3MgSi_2O_8$:D, $Ca_3SiO_4Cl_2$:D, $CaMgSi_2O_6$:D, $CaSiO_3$:D, $(Ca,Mg)SiO_3$:D, $(Ca,Sr)_2SiO_4$:D, $(Ba,Sr)_3SiO_5$:D, $(Ca,Sr)_3SiO_5$:D, $Gd_2SiO_5$:D, $K_2SiF_6$:D, $LaSiO_3Cl$:D, $LiCeBa_4Si_4O_{14}$:D, $LiCeSrBa_3Si_4O_{14}$:D, $LiNa(Mg,Mn)_2Si_4O_{10}F_2$:D, $Lu_2Si_2O_7$:D, $Lu_2SiO_5$:D, $(Lu,Gd)_2SiO_5$:D, $Mg_2SiO_4$:D, $Mg_3SiO_3F_4$:D, $MgBa_3Si_2O_8$:D, $MgSiO_3$:D, $MgSr_3Si_2O_8$:D, $Sr_2MgSi_2O_7$:D, $Sr_2SiO_4$:D, $Sr_3Gd_2Si_6O_{18}$:D, $Sr_5Si_4O_{10}Cl_6$:D, $SrBaSiO_4$:D, $SrMgSi_2O_6$:D, $Y_2Si_2O_7$:D, $Y_2SiO_5$:D, $Zn_2(Si,Ge)O_4$:D, $Zn_2SiO_4$:D und $(Zn,Be)_2SiO_4$:D.

Beispiele lumineszenter Phosphate oder Halophosphate umfassen: $M^{3+}PO_4$:D, $M^{2+}P_2O_6$:D, $M^{2+}_2P_2O_7$:D, $M^+_2M^{2+}P_2O_7$:D, $M^{4+}P_2O_7$:D, $M^{2+}B_2P_2O_9$:D, $M^{2+}_6BP_5O_{20}$:D, $M^{2+}_3(PO_4)_2$:D, $M^+_3M^{3+}(PO_4)_2$:D, $M^{2+}_6(PO_4)_4$:D und $M^{2+}_5(PO_4)_3X$:D, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; $M^{4+}$ Ti, Zr, Ge und/oder Sn ist; X ein oder mehrere Halogene, vorzugsweise F, Cl, Br und/oder I, ist; und D ein oder mehrere Aktivatoren, ausgewählt aus der Liste bestehend aus Eu, Ce, Mn, Tb, Sm, Cr, Sn, Pb, Sb, Bi, Cu und Ag, ist.

Bevorzugte Beispiele lumineszenter Phosphate und Halophosphate sind: $Ba_3(PO_4)_2$:D, $Ca_2Ba_3(PO_4)_3Cl$:D, $Ca_2P_2O_7$:D, $Ca_3(PO_4)_2$:D, $(Ca,Sr)_3(PO_4)_2$:D, $(Ca,Zn,Mg)_3(PO_4)_2$:D, $Ca_5(PO_4)_3(F,Cl)$:D, $Ca_5(PO_4)_3Cl$:D, $Ca_5(PO_4)_3F$:D, $CaB_2P_2O_9$:D, $CaP_2O_6$:D, $CaSr_2(PO_4)_2$:D, $LaPO_4$:D, $(La,Ce,Tb)PO_4$:D, $Li_2CaP_2O_7$:D, $LuPO_4$:D, $Mg_3Ca_3(PO_4)_4$:D, $MgBa_2(PO_4)_2$:D, $MgBaP_2O_7$:D, $MgCaP_2O_7$:D, $MgSr_5(PO_4)_4$:D, $MgSrP_2O_7$:D, $Na_3Ce(PO_4)_2$:D, $Sr_2P_2O_7$:D, $Sr_3(PO_4)_2$:D, $Sr_5(PO_4)_3Cl$:D, $Sr_5(PO_4)_3F$:D, $Sr_6BP_5O_{20}$:D, $YPO_4$:D, $Zn_3(PO_4)_2$:D, $Zn_3(PO_4)_2$:D, $ZnMg_2(PO_4)_2$:D und $(Zn,Mg)_3(PO_4)_2$:D.

Beispiele lumineszenter Borate, Haloborate oder Borosilikate umfassen: $M^{3+}BO_3$:D, $M^{2+}B_2O_4$:D, $M^{2+}_2B_2O_5$:D, $M^{3+}_2B_2O_6$:D, $M^{3+}B_3O_6$:D, $M^{2+}B_6O_{10}$:D, $M^{2+}M^{3+}BO_4$:D, $M^{2+}M^{3+}B_3O_7$:D, $M^{2+}B_4O_7$:D, $M^{2+}_3M^{3+}_2B_4O_{12}$:D, $M^{3+}_4B_4O_{12}$:D, $M^{3+}M^{2+}B_5O_{10}$:D, $M^{2+}_2B_6O_{11}$:D, $M^{2+}B_8O_{13}$:D, $M^{2+}_2B_5O_9X$:D, $M^{2+}_2M^{3+}_2BO_{6,5}$:D und $M^{2+}_5B_2SiO_{10}$:D, worin $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Ga, In, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; X ein oder mehrere Halogene, vorzugsweise F, Cl, Br und/oder I, ist; und D ein oder mehrere Aktivatoren, ausgewählt aus der Liste bestehend aus Eu, Ce, Mn, Tb, Sm, Cr, Sn, Pb, Sb, Bi, Cu und Ag, ist.

Bevorzugte Beispiele lumineszenter Borate und Borosilikate sind: $Ca_2B_2O_5$:D, $Ca_2B_5O_9Br$:D, $Ca_2B_5O_9Cl$:D, $Ca_2La_2BO_{6,5}$:D, $Ca_5B_2SiO_{10}$:D, $CaB_2O_4$:D, $CaLaB_3O_7$:D, $CaLaBO_4$:D, $CaYBO_4$:D, $Cd_2B_6O_{11}$:D, $GdMgB_5O_{10}$:D, $InBO_3$:D, $LaAl_3B_4O_{12}$:D, $LaAlB_2O_6$:D, $LaB_3O_6$:D, $LaBO_3$:D, $MgB_2O_4$:D, $MgYBO_4$:D, $ScBO_3$:D, $Sr_2B_5O_9Cl$:D, $SrB_4O_7$:D, $SrB_8O_{13}$:D, $YAl_3B_4O_{12}$:D, $YBO_3$:D, $(Y,Gd)BO_3$:D und $ZnB_2O_4,SrO$:D·$3B_2O_3$.

Beispiele lumineszenter Aluminate, Gallate oder Alumosilikate umfassen: $M^+AlO_2$:D, $M^{3+}AlO_3$:D, $M^{2+}M^{3+}AlO_4$:D, $M^{2+}Al_2O_4$:D, $M^{2+}Al_4O_7$:D, $M^+Al_5O_8$:D, $M^{3+}_4Al_2O_9$:D, $M^{3+}_3Al_5O_{12}$:D, $M^+Al_{11}O_{17}$:D, $M^{2+}_2Al_{10}O_{17}$:D, $M^{3+}_3Al_5O_{12}$:D, $M^{3+}_3(Al,Ga)_5O_{12}$:D, $M^{3+}_3Sc_2Al_3O_{12}$:D, $M^{2+}_2Al_6O_{11}$:D, $M^{2+}Al_8O_{13}$:D, $M^{2+}M^{3+}Al_{11}O_{19}$:D, $M^{2+}Al_{12}O_{19}$:D, $M^{2+}_4Al_{14}O_{25}$:D, $M^{2+}_3Al_{16}O_{27}$:D, $M^{2+}Ga_2O_4$:D, $M^{2+}Ga_4O_7$:D, $M^{3+}_3Ga_5O_{12}$:D, $M^+Ga_{11}O_{17}$:D, $M^{2+}Ga_{12}O_{19}$:D, $M^+_2M^{3+}_2Al_2Si_2O_{10}$:D und $M^{2+}_3Al_2Si_3O_{12}$:D, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und D ein oder mehrere Aktivatoren, ausgewählt aus der Liste bestehend aus Eu, Ce, Mn, Tb, Sm, Cr, Sn, Pb, Sb, Bi, Cu und Ag, ist.

Bevorzugte Beispiele lumineszenter Aluminate, Gallate und Alumosilikate sind: $BaAl_{12}O_{19}$:D, $BaAl_8O_{13}$:D, $BaMgAl_{10}O_{17}$:D, $CaAl_2O_4$:D, $CaAl_4O_7$:D, $(Ca,Ba)Al_{12}O_{19}$:D, $CaGa_2O_4$:D, $CaGa_4O_7$:D, $CeMgAl_{11}O_{19}$:D, $Gd_3Ga_5O_{12}$:D, $Gd_3Sc_2Al_3O_{12}$:D, $GdAlO_3$:D, $KAl_{11}O_{17}$:D, $KGa_{11}O_{17}$:D, $LaAlO_3$:D, $LaMgAl_{11}O_{19}$:D, $LiAl_5O_8$:D, $LiAlO_2$:D, $LiAlO_2$:D, $Lu_3Al_5O_{12}$:D, $LuAlO_3$:D, $(Lu,Y)AlO_3$:D, $MgAl_2O_4$:D, $MgGa_2O_4$:D, $MgSrAl_{10}O_{17}$:D, $Sr_2Al_6O_{11}$:D, $Sr_4Al_{14}O_{25}$:D, $SrAl_{12}O_{19}$:D, $SrAl_2O_4$:D, $SrAl_4O_7$:D, $SrGa_{12}O_{19}$:D, $SrGa_2O_4$:D, $Tb_3Al_5O_{12}$:D, $Y_3(Al,Ga)_5O_{12}$:D, $(Y,Gd)_3Al_5O_{12}$:D, $Y_3Al_5O_{12}$:D, $Y_4Al_2O_9$:D, $YAlO_3$:D, $ZnAl_2O_4$:D und $ZnGa_2O_4$:D.

Beispiele lumineszenter Molybdate oder Wolframate umfassen: $M^{2+}MoO_4$:D, $M^+M^{3+}Mo_2O_8$:D, $M^{2+}WO_4$:D, $M^{2+}_3WO_6$:D, $M^{3+}_2W_3O_{12}$:D und $M^+M^{3+}W_2O_8$:D, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und X ein oder mehrere Halogene, vorzugsweise F, Cl, Br und/oder I, ist; und D ein oder mehrere Aktivatoren, ausgewählt aus der Liste bestehend aus Eu, Ce, Mn, Tb, Sm, Cr, Sn, Pb, Sb, Bi, Cu und Ag, ist.

Bevorzugte Beispiele lumineszenter Molybdate und Wolframate sind: $Ba_3WO_6$:D, $Ca_3WO_6$:D, $CaMoO_4$:D, $CaWO_4$:D, $CdWO_4$:D, $La_2W_3O_{12}$:D, $LiEuMo_2O_8$:D, $MgWO_4$:D, $Sr_3WO_6$:D, $SrMoO_4$:D, $Y_2W_3O_{12}$:D und $ZnWO_4$:D.

Beispiele lumineszenter Sulfate, Sulfide, Selenide oder Telluride umfassen: $M^{2+}SO_4$:D, $M^{2+}_2(SO_4)_2$:D, $M^{2+}_3$

$(SO_4)_3$:D, $M^{3+}_2(SO_4)_3$:D, $M^{2+}S$:D, $M^{2+}(S,Te)$:D, $M^{2+}Se$:D, $M^{2+}Te$:D, $M^{2+}Ga_2S_4$:D, $M^{2+}Ba_2S_3$:D und $M^{2+}Al_2S_4$:D, worin $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La, und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; und D ein oder mehrere Aktivatoren, ausgwählt aus der Liste bestehend aus Eu, Ce, Mn, Tb, Sm, Cr, Sn, Pb, Sb, Bi, Cu und Ag, ist.

Bevorzugte Beispiele lumineszenter Sulfate, Sulfide, Selenide und Telluride sind: $CaGa_2S_4$:D, $CaS$:D, $CaSO_4$:D, $CdS$:D, $Mg_2Ca(SO_4)_3$:D, $Mg_2Sr(SO_4)_3$:D, $MgBa(SO_4)_2$:D, $MgS$:D, $MgSO_4$:D, $SrAl_2S_4$:D, $SrGa_2S_4$:D, $SrS$:D, $SrSO_4$:D, $Zn(S,Te)$:D, $ZnBa_2S_3$:D, $ZnGa_2S_4$:D, $ZnS$:D, $(Zn,Cd)S$:D und $ZnSe$:D.

Beispiele lumineszenter Nitride, Oxynitride oder SiAlONe umfassen: $M^{3+}N$:D, $M^{2+}Si_2O_2N_2$:D, $M^{2+}_2Si_5N_8$:D, $M^{3+}_3Si_6N_{11}$:D, $M^{2+}AlSiN_3$:D, $\alpha$-SiAlONe:D und ß-SiAlONe:D, worin $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Ga, Sc, Y, La und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; D ein oder mehrere Aktivatoren, ausgwählt aus der Liste bestehend aus Eu, Ce, Mn, Tb, Sm, Cr, Sn, Pb, Sb, Bi, Cu und Ag, ist.

Bevorzugte Beispiele lumineszenter Nitride und Oxynitride sind: $Ba_2Si_5N_8$:D, $Ca_2Si_5N_8$:D, $CaAlSiN_3$:D, $(Ca,Sr)AlSiN_3$:D, $GaN$:D, $La_3Si_6N_{11}$:D, $Sr_2Si_5N_8$:D und $(Sr,Ba)Si_2N_2O_2$:D.

Beispiele lumineszenter komplexer Metall-Sauerstoff-Verbindungen umfassen: $M^{3+}AsO_4$:D, $M^{2+}_{13}As_2O_{18}$:D, $M^{2+}GeO_3$:D, $M^{2+}_2GeO_4$:D, $M^{2+}_4GeO_6$:D, $M^{2+}_4(Ge,Sn)O_6$:D, $M^{2+}_2Ge_2O_6$:D, $M^{3+}_4Ge_3O_{12}$:D, $M^{2+}_5GeO_4X_6$:D, $M^{2+}_8Ge_2O_{11}X_2$:D, $M^+InO_2$:D, $M^{2+}In_2O_4$:D, $M^+LaO_2$:D, $M^{2+}La_4O_7$:D, $M^{3+}NbO_4$:D, $M^{2+}Sc_2O_4$:D, $M^{2+}_2SnO_4$:D, $M^{3+}TaO_4$:D, $M^{2+}TiO_3$:D, $M^{2+}_2TiO_4$:D, $M^+_2M^{3+}_2Ti_3O_{10}$:D, $M^{2+}_5(VO_4)_3X$:D, $M^{3+}VO_4$:D, $M^{3+}(V,P)O_4$:D, $M^+YO_2$:D, $M^{2+}ZrO_3$:D, $M^{2+}_2ZrO_4$:D und $M^{2+}M^{3+}_2ZrO_6$:D, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La, Bi und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; $M^{4+}$ Ti, Zr, Ge und/oder Sn ist; X ein oder mehrere Halogene, vorzugsweise F, Cl, Br und/oder I, ist; und D ein oder mehrere Aktivatoren, ausgwählt aus der Liste bestehend aus Sc, Eu, Ce, Mn, Tb, Sm, Cr, Sn, Pb, Sb, Bi, Cu und Ag, ist.

Bevorzugte Beispiele lumineszenter komplexer Metall-Sauerstoff-Verbindungen sind: $Ba_5GeO_4Br_6$:D, $Bi_4Ge_3O_{12}$:D, $Ca_5(VO_4)_3Cl$:D, $CaGeO_3$:D, $CaLa_4O_7$:D, $CaSc_2O_4$:D, $CaTiO_3$:D, $CaY_2ZrO_6$:D, $GdNbO_4$:D, $GdTaO_4$:D, $K_2La_2Ti_3O_{10}$:D, $LaAsO_4$:D, $LaVO_4$:D, $LiInO_2$:D, $LiLaO_2$:D, $LuTaO_4$:D, $Mg_{13}As_2O_{18}$:D, $Mg_2SnO_4$:D, $Mg_2TiO_4$:D, $Mg_4(Ge,Sn)O_6$:D, $Mg_4GeO_6$:D, $Mg_8Ge_2O_{11}F_2$:D, $NaYO_2$:D, $SrTiO_3$:D, $Y(V,P)O_4$:D, $YAsO_4$:D, $YTaO_4$:D, $YVO_4$:D und $Zn_2GeO_4$:D.

Beispiele lumineszenter Halogen- oder Oxy-Verbindungen umfassen: $M^+X$:D, $M^{2+}X_2$:D, $M^{3+}X_3$:D, $M^+M^{2+}X_3$:D, $M^+M^{3+}X_4$:D, $M^{2+}M^{3+}_2X_8$:D, $M^+M^{3+}_3X_{10}$:D, $M^{3+}OX$:D, $M^{2+}_8M^{4+}_2O_{11}X_2$:D und $M^{3+}_2O_2S$:D, worin $M^+$ ein oder mehrere Alkalimetalle, vorzugsweise Li, Na und/oder K, ist; $M^{2+}$ Zn, Fe, Co, Ni, Cd, Cu und/oder ein oder mehrere Erdalkalimetalle, vorzugsweise Be, Mg, Ca, Sr und/oder Ba, ist; $M^{3+}$ Al, Sc, Y, La, und/oder ein oder mehrere Seltenerdmetalle, ausgewählt aus Sc, Y, La, Ce, Pr, Nd, Pm, Sm, Eu, Gd, Tb, Dy, Ho, Er, Tm, Yb und Lu, ist; X ein oder mehrere Halogene, vorzugsweise F, Cl, Br und/oder I, ist; und D ein oder mehrere Aktivatoren, ausgwählt aus der Liste bestehend aus Eu, Ce, Mn, Tb, Sm, Cr, Sn, Pb, Sb, Bi, Cu und Ag, ist.

Bevorzugte Beispiele lumineszenter Halogen-Verbindungen sind: $BaBr_2$:D, $BaCl_2$:D, $BaF_2$:D, $(Ba,Sr)F_2$:D, $BaFBr$:D, $BaFCl$:D, $BaY_2F_8$:D, $CaBr_2$ in $SiO_2$:D, $CaCl_2$ in $SiO_2$:D, $CaF_2$:D, $CaI_2$ in $SiO_2$:D, $CeF_3$:D, $CsF$:D, $CsI$:D, $KMgF_3$:D, $KY_3F_{10}$:D, $LaBr_3$:D, $LaCl_3$:D, $LaF_3$:D, $LiAlF_4$:D, $LiYF_4$:D, $MgF_2$:D, $NaI$:D, $NaYF_4$:D, $RbBr$:D, $Sr(Cl,Br,I)_2$:D in $SiO_2$, $SrCl_2$ in $SiO_2$:D, $SrF_2$:D, $YF_3$:D, $ZnF_2$:D und $(Zn,Mg)F_2$:D.

Bevorzugte Beispiele lumineszenter Oxy-Verbindungen sind Oxysulfide und Oxyhalogenide, ausgewählt aus: $Gd_2O_2S$:D, $La_2O_2S$:D, $LaOBr$:D, $LaOCl$:D, $LaOF$:D, $Y_2O_2S$:D, $YOBr$:D, $YOCl$:D und $YOF$:D.

Bevorzugte lumineszente SiAlONe sind $\alpha$-SiAlONe:D und ß-SiAlONe:D.

Besonders bevorzugte Aktivatoren D für alle der oben genannten Leuchtstoffverbindungen sind Eu(II), Ce(III), Mn(II), Mn(IV), Eu(III), Tb(III), Sm(III), Cr(III), Sn(II), Pb(II), Sb(III), Bi(III), Cu(I) und Ag(I) sowie Mischungen davon.

In einer besonders bevorzugten Ausführungsform der vorliegenden Erfindung ist das Lumineszenzmaterial ein anorganischer Leuchtstoff, ausgewählt aus der Liste bestehend aus $M^{2+}_2SiO_4$:D, $M^{2+}_3SiO_5$:D, ß-SiAlONen:D, und $M^{2+}AlSiN_3$:D, wobei $M^{2+}$ Be, Mg, Ca, Sr und/oder Ba ist und D Eu(II) ist, sowie $M^{3+}_3(Al,Ga)_5O_{12}$:D, wobei $M^{3+}$ Y, Lu, Tb und/oder Gd ist und D Ce(III) ist.

Für Halbleiter-Nanopartikel, die im grünen Spektralbereich von 520 bis 540 nm emittieren, sind besonders bevorzugte Lumineszentmaterialien Eu(II)-aktivierte Ba-Sr-Orthosilikate mit einer Peakemission im Bereich von 510 bis 530 nm. Derartige Eu(II)-aktivierte Ba-Sr-Orthosilikate lassen sich durch die folgende Summenformel darstellen: $(Ba,Sr)_2SiO_4$:Eu(II). Der Dotierungsgrad liegt typischerweise im Bereich von 0,5 bis 5 Atom-%.

Für Halbleiter-Nanopartikel, die im orangen Spektralbereich von 576 bis 600 nm emittieren, sind besonders bevorzugte Lumineszentmaterialien Eu(II)-aktivierte Ba-Sr-Oxyorthosilikate mit einer Peakemission im Bereich von 585 bis 600 nm. Derartige Eu(II)-aktivierte Ba-Sr-Oxyorthosilikate lassen sich durch die folgende Summenformel darstellen: $(Ba,Sr)_3SiO_5$:Eu(II). Der Dotierungsgrad liegt typischerweise im Bereich von 0,5 bis 5 Atom-%.

Für Halbleiter-Nanopartikel, die im roten Spektralbereich von 620 bis 640 nm emittieren, sind besonders bevorzugte Lumineszentmaterialien Eu(II)-aktivierte Ca-Sr-Al-Si-Nitride mit einer Peakemission im Bereich von 610 bis 630 nm. Derartige Eu(II)-aktivierte Ca-Sr-Al-Si-Nitride lassen sich durch die folgende Summenformel darstellen: $(Ca,Sr)AlSiN_3$:Eu(II). Der Dotierungsgrad liegt typischerweise im Bereich von 0,5 bis 5 Atom-%.

Die genannten Beispiele der Lumineszenzmaterialien dienen alleine der Veranschaulichung und sind hinsichtlich des Umfangs und des Schutzbereichs der vorliegenden Erfindung in keinster Weise als einschränkend zu verstehen.

Halbleiter-Nanopartikel, die in dem lichtkonvertierenden Material der vorliegenden Erfindung verwendet werden können, sind Halbleitermaterialien in Submikrometergröße, die in der Lage sind, Licht mit einer bestimmten Wellenlänge zu emittieren, wenn sie mit einer optischen Anregungsstrahlung mit einem anderen (kürzeren) Wellenlängenbereich bestrahlt werden. Halbleiter-Nanopartikel werden häufig auch als Quantenmaterialien bezeichnet. Das von Quantenmaterialien emittierte Licht zeichnet sich durch einen sehr engen Frequenzbereich aus.

In einer bevorzugten Ausführungsform der vorliegenden Erfindung umfassen die Halbleiter-Nanopartikel mindestens zwei verschiedene Halbleitermaterialien. Die Halbleiter-Nanopartikel liegen vorzugsweise als Legierung oder in einer Kern-Schale-Konfiguration bzw. Kern-Mehrschalen-Konfiguration mit mindestens zwei Schalen vor, wobei der Kern entweder ein Halbleitermaterial oder eine Legierung aus mindestens zwei verschiedenen Halbleitermaterialien enthält und die Schale(n) unabhängig ein Halbleitermaterial oder eine Legierung aus mindestens zwei verschiedenen Halbleitermaterialien enthalten, wobei wahlweise ein Konzentrationsgradient innerhalb des Kerns und/oder der Schale(n) und/oder zwischen dem Kern und/oder den Schale(n) vorliegen kann.

In einer besonders bevorzugten Ausführungsform sind die Halbleitermaterialien oder die Legierungen aus mindenstens zwei verschiedenen Halbleitermaterialien im Kern und der benachbartern Schale und/oder in benachbarten Schalen verschieden. Aufgrund der Toxizität von Cd wird bevorzugt ZnS als Schalenmaterial eingesetzt. Dies hat den Nachteil, dass die Quantenmaterialien im typischen Bereich der blauen LED um 450 nm weniger gut absorbieren. Hier führt die zusätzliche Absorption der Emission des Lumineszenzmaterials der vorliegenden Erfindung zu einem besonders großen Vorteil in der Endanwendung.

Wie bereits zuvor beschrieben, werden die Halbleiter-Nanopartikel, die sich für die Zwecke der vorliegenden Erfindung eignen, aus Halbleitermaterialien hergestellt. Mögliche Materialzusammensetzungen der für die vorliegende Erfindung geeigneten Halbleiter-Nanopartikel werden in der WO 2010/095140 A3 und WO 2011/092646 A2 beschrieben.

Die Halbleitermaterialien werden vorzugsweise ausgewählt aus Gruppe II-VI-Halbleitern, Gruppe III-V-Halbleitern, Gruppe IV-VI-Halbleitern, Gruppe I-III-VI$_2$-Halbleitern sowie aus Legierungen und/oder Kombinationen dieser Halbleiter, wobei die Halbleitermaterialien wahlweise mit einem oder mehreren Übergangsmetallen, wie beispielsweise Mn und/oder Cu, dotiert sein können (vgl. M. J. Anc, N. L. Pickett et al., ECS Journal of Solid State Science and Technology, 2013, 2(2), R3071-R3082).

Beispiele von Halbleitermaterialien der Gruppe II-VI sind: CdSe, CdS, CdTe, ZnO, ZnSe, ZnS, ZnTe, HgS, HgSe, HgTe, CdZnSe sowie beliebige Kombinationen davon.

Beispiele von Halbleitermaterialien der Gruppe III-V sind: InAs, InP, InN, GaN, InSb, InAsP, InGaAs, GaAs, GaP, GaSb, AlP, AlN, AlAs, AlSb, CdSeTe, ZnCdSe sowie beliebige Kombinationen davon.

Beispiele von Halbleitermaterialien der Gruppe IV-VI sind: PbSe, PbTe, PbS, PbSnTe, $Tl_2SnTe_5$ sowie beliebige Kombinationen davon.

Beispiele von Halbleitermaterialien der Gruppe I-III-VI$_2$ sind: $CuGaS_2$, $CuGaSe_2$, $CuInS_2$, $CuInSe_2$, $Cu_2(InGa)S_4$, $AgInS_2$, $AgInSe_2$ sowie beliebige Kombinationen davon.

Die genannten Beispiele der Halbleitermaterialien für die Halbleiter-Nanopartikel dienen alleine der Veranschaulichung und sind hinsichtlich des Umfangs und des Schutzbereichs der vorliegenden Erfindung in keinster Weise als einschränkend zu verstehen. Die genannten Halbleitermaterialien können entweder als Legierung oder als Kern- oder Schalenmaterial in einer Kern-Schale-Konfiguration oder in einer Kern-Mehrschalen-Konfiguration verwendet werden.

Die äußere und innere Form der Halbleiter-Nanopartikel ist nicht weiter beschränkt. Vorzugsweise liegen die Halbleiter-Nanopartikel in Form von Nanopunkten, Nanostäbchen, Nanoplättchen, Nanotetrapods, Nanopunkten in Nanostäbchen, Nanostäbchen in Nanostäbchen und/oder Nanopunkten in Nanoplättchen vor.

Die Länge der Nanostäbchen liegt vorzugsweise zwischen 8 und 500 nm und stärker bevorzugt zwischen 10 und 160 nm. Der Gesamtdurchmesser eines Nanostäbchens liegt vorzugsweise zwischen 1 und 20 nm und stärker bevorzugt zwischen 1 und 10 nm. Ein typisches Nanostäbchen hat ein Seitenverhältnis (Länge zu Durchmesser) von vorzugsweise größer oder gleich 2 und stärker bevorzugt von größer oder gleich 3.

In einer stärker bevorzugten Ausführungsform weisen die Halbleiter-Nanopartikel eine hohe Absorption im Bereich der eigenen Emission (Eigenabsorption) auf. Dies ist typischerweise bei Materialien mit ZnS-Schale oder sehr kleiner Schale der Fall.

Die Wellenlänge des emittierten Lichts (Emissionsfarbe) der Halbleiter-Nanopartikel in Antwort auf die Anregungsstrahlung kann in geeigneter Weise durch Einstellen der Form, Größe und/oder der stofflichen Zusammensetzung der Nanopartikel gewählt werden. Diese Flexibilität hinsichtlich der Emissionsfarbe ermöglicht eine große Variation der Farbe des erfindungsgemäßen lichtkonvertierenden Materials. Die Emission von rotem Licht kann beispielsweise durch CdSe-Nanopunkte, CdSe-Nanostäbchen, CdSe-Nanopunkte in CdS-Nanostäbchen, ZnSe-Nanopunkte in CdS-Nanostäbchen, CdSe/ZnS-Nanostäbchen, InP-Nanopunkte, InP-Nanostäbchen, CdSe/CdS-Nanostäbchen, ZnSe-Nanopunkte in CdS-Nanostäbchen und ZnSe/CdS-Nanostäbchen erzielt werden. Die Emission von grünem Licht kann beispielsweise durch CdSe-Nanopunkte, CdSe-Nanostäbchen, CdSe/CdS-Nanostäbchen und CdSe/ZnS-Nanostäbchen erzielt werden. Die Emission von blauem Licht kann beispielsweise durch Kern-Schale-Nanopunkte oder Kern-Schale-Nanostäbchen auf der Basis von ZnSe, ZnS, ZnSe/ZnS und/oder CdS erzielt werden. Diese beispielhafte Zuordnung zwischen bestimmten Halbleiter-Nanopartikeln und bestimmten Emissionsfarben ist nicht abschließend und soll lediglich der Veranschaulichung dienen. Dem Fachmann ist bewusst, dass durch Einstellen der Größe der Halbleiter-Nanopartikel verschiedene Emissionsfarben innerhalb bestimmter materialabhängiger Grenzen erzielt werden können.

Weitere bevorzugte Halbleiter-Nanopartikel sind Nanostäbchen mit einer Kern-Schale-Konfiguration mit Materialien, ausgewählt aus CdSe/CdS, CdSeS/CdS, ZnSe/CdS, ZnCdSe/CdS, CdSe/CdZnS, CdTe/CdS, InP/ZnSe, InP/CdS, InP/ZnS und CuInS$_2$/ZnS; sowie Nanostäbchen mit einer Kern-Mehrschalen-Konfiguration, ausgewählt aus CdSe/CdS/ZnS, CdSe/CdZnS/ZnS, ZnSe/CdS/ZnS, InP/ZnSe/ZnS, InP/CdS/ZnS und InP/CdZnS/ZnS.

In einer bevorzugten Ausführungsform werden die Halbleiter-Nanopartikel auf die Oberfläche eines Lumineszenzmaterialss, wie oben beschrieben, aufgebracht, so dass die Halbleiter-Nanopartikel in einem Verhältnis von 0,01 bis 20 Gew.-%, vorzugsweise von 0,1 bis 5 Gew.-%, bezogen auf das Lumineszenzmaterial, vorliegen.

In einer bevorzugten Ausführungsform ist die Oberfläche der Halbleiter-Nanopartikel mit einem oder mehreren Liganden beschichtet. Die Liganden unterliegen keiner besonderen Einschränkung, sofern sie sich für die Oberflächenbeschichtung von Halbleiter-Nanopartikeln eignen. Geeignete Liganden sind beispielsweise Phosphine und Phosphinoxide, wie Trioctylphosphinoxid (TOPO), Trioctylphosphin (TOP) oder Tributylphosphin (TBP); Phosphonsäuren, wie Dodecylphosphonsäure (DDPA), Tridecylphosphonsäure (TBPA), Octadecylphosphonsäure (ODPA) oder Hexylphosphonsäure (HPA); Amine, wie Dodecylamin (DDA), Tetradecylamin (TDA), Hexadecylamin (HDA) oder Octadecylamin (ODA); Thiole, wie Hexadecanthiol oder Hexanthiol; Mercaptocarbonsäuren, wie Mercaptopropionsäure oder Mercaptoundecansäure; und andere Säuren, wie Myristinsäure, Palmitinsäure, Ölsäure, Capronsäure oder Adipinsäure. Es ist nicht beabsichtigt, dass die zuvor genannten Beispiele als einschränkend zu verstehen sind.

Es ist ferner bevorzugt, dass die Oberfläche des lichtkonvertierenden Materials der vorliegenden Erfindung mit einem oder mehreren Beschichtungsmaterialien beschichtet ist. Die Beschichtungsmaterialien unterliegen keiner besonderen Einschränkung, sofern sie sich für die Beschichtung der Oberfläche des lichtkonvertierenden Materials eignen. Geeignet sind beispielsweise Materialien, die auch für die Beschichtung von Leuchtstoffen verwendet werden, wie beispielsweise anorganische oder organische Beschichtungsmaterialien. Die anorganischen Beschichtungsmaterialien können dielektrische Isolatoren, Metalloxide (einschließlich transparenter leitfähiger Oxide), Metallnitride oder Siliciumdioxid-basierte Materialien (z.B. Gläser) sein. Wenn ein Metalloxid verwendet wird, kann das Metalloxid ein einzelnes Metalloxid (d.h. Oxidionen, die mit einem einzelnen Metallion-Typ kombiniert sind, wie z.B. Al$_2$O$_3$) oder ein gemischtes Metalloxid (d.h. Oxidionen, die mit zwei oder mehr Metallion-Typen kombiniert sind, wie z.B. SrTiO$_3$, oder ein dotiertes Metalloxid, wie ein dotiertes transparentes leitfähiges Oxid (TCO), wie z.B. Al-dotiertes ZnO, Ga-dotiertes ZnO, etc.) sein. Das Metallion oder die Metallionen des (gemischten) Metalloxids können aus jeder geeigneten Gruppe des Periodensystems ausgewählt werden, wie beispielsweise Gruppe 2, 13, 14 oder 15, oder sie können ein d-Metall oder ein Lanthanidmetall sein.

Besondere Metalloxide schließen ein, sind jedoch nicht beschränkt auf: Al$_2$O$_3$, ZnO, HfO$_2$, SiO$_2$, ZrO$_2$ und TiO$_2$, einschließlich Kombinationen, Legierungen und/oder dotierte Spezies davon; und/oder TCOs, wie z.B. Al-dotiertes ZnO, Ga-dotiertes ZnO und In$_2$O$_3$. Die anorganischen Beschichtungen schließen Siliciumdioxid in jeder geeigneten Form ein. In einigen Ausführungsformen ist ein oder mehrere der anorganischen Beschichtungsmaterialien ein Metalloxid, das aus der Gruppe bestehend aus Al$_2$O$_3$, ZnO, TiO$_2$, In$_2$O$_3$ oder Kombinationen und/oder dotierten Spezies davon ausgewählt ist. In besonderen Ausführungsformen ist das Metalloxid ein TCO, z.B. Al-dotiertes ZnO oder Ga-dotiertes ZnO.

Besondere Metallnitride schließen ein, sind jedoch nicht beschränkt auf: AlN, BN, Si$_3$N$_4$, einschließlich Kombinationen, Legierungen und/oder dotierte Spezies davon.

Es ist auch möglich, alternativ und/oder zusätzlich zu der oben genannten anorganischen Beschichtung eine organische Beschichtung aufzubringen. Die organische Beschichtung kann sich ebenfalls vorteilhaft auf die Stabilität und Haltbarkeit der lichtkonvertierenden Materialien sowie die Dispergierbarkeit auswirken. Geeignete organische Materialien sind (Poly)silazane, wie vorzugsweise modifizierte organische Polysilazane (MOPS) oder Perhydropolysilazane (PHPS), sowie Mischungen davon, organische Silane und auch andere organische Materialien bis hin zu Polymeren.

Im Stand der Technik sind zahlreiche Verfahren zum Aufbringen von Beschichtungsmaterialien auf lichtkonvertierende Materialien oder Leuchtstoffe bekannt. So beschreibt beispielsweise die WO 2014/140936, deren Inhalt hiermit durch Bezugnahme in die vorliegende Anmeldung aufgenommen wird, Verfahren, wie beispielsweise die chemische Gasphasenabscheidung (CVD), physikalische Gasphasenabscheidung (PVD) (einschließlich Magnetron-Sputtern), Vitex-Technologie, Atomschichtabscheidung (ALD) und Molekularschichtabscheidung (MLD). Ferner kann die Beschichtung durch ein Wirbelschichtverfahren durchgeführt werden. Weitere Beschichtungsverfahren werden in der JP 04-304290, WO 91/10715, WO 99/27033, US 2007/0298250, WO 2009/065480 und WO 2010/075908 beschrieben, deren Inhalte hiermit durch Bezugnahme eingeschlossen werden.

Um eine mehrschichtige Beschichtung aufzubauen, können nacheinander unterschiedliche Beschichtungsmaterialien aufgebracht werden. Zahlreiche Beschichtungsmaterialien, wie beispielsweise Metalloxide, wie z.B. $Al_2O_3$, $SiO_2$, $ZnO$, $TiO_2$ und $ZrO_2$; Metalle, wie z.B. Pt und Pd; und Polymere, wie z.B. Poly(amide) und Poly(imide), können für die Beschichtung des lichtkonvertierenden Materials gemäß der vorliegenden Erfindung verwendet werden. $Al_2O_3$ ist eines der am besten untersuchten Beschichtungsmaterialien, das mit Hilfe des Atomschichtabscheidungs-(ALD)-Verfahrens aufgebracht wird. $Al_2O_3$ kann durch wechselseitiges Anwenden von Trimethylaluminium und Wasserdampf als entsprechende Metall- und Sauerstoffquellen und Spülen der ALD-Kammer zwischen jeder dieser Anwendungen mit einem inerten Trägergas, wie z.B. $N_2$ oder Ar, auf einem Substrat aufgebracht werden.

In einer besonders bevorzugten Ausführungsform der vorliegenden Erfindung umfasst das lichtkonvertierende Material noch mindestens eine weitere Art von Halbleiter-Nanopartikeln, die sich ebenfalls auf der Oberfläche des Lumineszenzmaterials befinden und deren Emission nicht im Bereich der Emission des Lumineszenzmaterials liegt. Dies bedeutet, dass die oben genannten Gleichungen (1) bis (9) für die mindestens eine weitere Art von Halbleiter-Nanopartikeln nicht erfüllt sein müssen.

Das erfindungsgemäße lichtkonvertierende Material wird hergestellt, indem (A) eine Suspension eines Lumineszenzmaterials in einem Lösungsmittel bereitgestellt wird; und (B) eine Suspension von Halbleiter-Nanopartikeln in einem Lösungsmittel hinzugegeben wird.

Bevorzugte Lösungsmittel für die Suspension des Lumineszenzmaterials sind Wasser, Methanol, Ethanol und Toluol.

Bevorzugte Lösungsmittel für die Suspension der Halbleiter-Nanopartikel sind PGMEA (1-Methoxy-2-propylacetat), Toluol, Methanol, Ethanol und Wasser.

Nach Zugabe der Halbleiter-Nanopartikel-Suspension wird das Gemisch vorzugsweise bei Raumtemperatur (20 bis 25°C) für 0,5 bis 5 h gerührt bevor anschließend die Lösungsmittel bei erhöhter Temperatur, vorzugsweise 40 bis 60°C, unter Vakuum entfernt werden.

Die vorliegende Erfindung stellt ferner eine lichtkonvertierende Mischung bereit, die eines oder mehrere der erfindungsgemäßen lichtkonvertierenden Materialien umfasst. Es ist bevorzugt, dass die lichtkonvertierende Mischung neben dem lichtkonvertierenden Material zusätzlich mindestens ein weiteres Lumineszenzmaterial umfasst.

Es ist besonders bevorzugt, dass die lichtkonvertierende Mischung neben den erfindungsgemäßen lichtkonvertierenden Materialien einen oder mehrere Konversionsleuchtstoffe enthält. Es ist bevorzugt, dass die lichtkonvertierenden Materialien und die Konversionsleuchtstoffe Licht unterschiedlicher Wellenlängen emittieren, die komplementär zueinander sind. Wenn es sich bei dem erfindungsgemäßen lichtkonvertierenden Material um ein rot emittierendes Material handelt, wird dieses bevorzugt in Kombination mit einem cyan emittierenden Konversionsleuchtstoff oder in Kombination mit blau und grün bzw. gelb emittierenden Konversionsleuchtstoffen eingesetzt. Wenn es sich bei dem erfindungsgemäßen lichtkonvertierenden Material um ein grün emittierendes Material handelt, wird dieses bevorzugt in Kombination mit einem magenta emittierenden Konversionsleuchtstoff oder in Kombination mit rot und blau emittierenden Konversionsleuchtstoffen eingesetzt. Es kann also bevorzugt sein, dass das erfindungsgemäße lichtkonvertierende Material in Kombination mit einem oder mehreren weiteren Konversionsleuchtstoffen in der erfindungsgemäßen lichtkonvertierenden Mischung eingesetzt wird, so dass vorzugsweise weißes Licht emittiert wird.

Es ist bevorzugt, dass die lichtkonvertierende Mischung das erfindungsgemäße lichtkonvertierende Material in einem Verhältnis von 1 bis 90 Gew.-%, bezogen auf das Gesamtgewicht der Mischung, umfasst.

Im Kontext dieser Anmeldung wird als ultraviolettes Licht solches Licht bezeichnet, dessen Emissionsmaximum zwischen 100 und 399 nm liegt, als violettes Licht solches Licht bezeichnet, dessen Emissionsmaximum zwischen 400 und 430 nm liegt, als blaues Licht solches Licht bezeichnet, dessen Emissionsmaximum zwischen 431 und 480 nm liegt, als cyanfarbenes Licht solches, dessen Emissionsmaximum zwischen 481 und 510 nm liegt, als grünes Licht solches, dessen Emissionsmaximum zwischen 511 und 565 nm liegt, als gelbes Licht solches, dessen Emissionsmaximum zwischen 566 und 575 nm liegt, als oranges Licht solches, dessen Emissionsmaximum zwischen 576 und 600 nm liegt und als rotes Licht solches, dessen Emissionsmaximum zwischen 601 und 750 nm liegt.

Das erfindungsgemäße lichtkonvertierende Material ist vorzugsweise ein rot- oder grün-emittierendes Konversionsmaterial.

Die Konversionsleuchtstoffe, die zusammen mit dem erfindungsgemäßen lichtkonvertierenden Material eingesetzt werden können und die erfindungsgemäße lichtkonvertierende Mischung bilden, unterliegen keiner besonderen Einschränkung. Es kann daher generell jeder mögliche Konversionsleuchtstoff eingesetzt werden. Dabei eignen sich beispielsweise: $Ba_2SiO_4:Eu^{2+}$, $Ba_3SiO_5:Eu^{2+}$, $(Ba,Ca)_3SiO_5:Eu^{2+}$, $BaSi_2N_2O_2:Eu$, $BaSi_2O_5:Pb^{2+}$, $Ba_3Si_6O_{12}N_2:Eu$, $Ba_xSr_{1-x}F_2:Eu^{2+}$ (mit $0 \leq x \leq 1$), $BaSrMgSi_2O_7:Eu^{2+}$, $BaTiP_2O_7$, $(Ba,Ti)_2P_2O_7:Ti$, $BaY_2F_8:Er^{3+},Yb^+$, $Be_2SiO_4:Mn^{2+}$, $Bi_4Ge_3O_{12}$, $CaAl_2O_4:Ce^{3+}$, $CaLa_4O_7:Ce^{3+}$, $CaAl_2O_4:Eu^{2+}$, $CaAl_2O_4:Mn^{2+}$, $CaAl_4O_7:Pb^{2+},Mn^{2+}$, $C_aAl_2O_4:Tb^{3+}$, $Ca_3Al_2Si_3O_{12}:Ce^{3+}$, $Ca_3Al_2Si_3O_{12}:Ce^{3+}$, $Ca_3Al_2Si_3O_{12}:Eu^{2+}$, $Ca_2B_5O_9Br:Eu^{2+}$, $Ca_2B_5O_9Cl:Eu^{2+}$, $Ca_2B_5O_9Cl:Pb^{2+}$, $CaB_2O_4:Mn^{2+}$, $Ca_2B_2O_5:Mn^{2+}$, $CaB_2O_4:Pb^{2+}$, $CaB_2P_2O_9:Eu^{2+}$, $Ca_5B_2SiO_{10}:Eu^{3+}$, $Ca_{0,5}Ba_{0,5}Al_{12}O_{19}:Ce^{3+},Mn^{2+}$, $Ca_2Ba_3$

$(PO_4)_3Cl:Eu^{2+}$, $CaBr_2:Eu^{2+}$ in $SiO_2$, $CaCl_2:Eu^{2+}$ in $SiO_2$, $CaCl_2:Eu^{2+},Mn^{2+}$ in $SiO_2$, $CaF_2:Ce^{3+}$, $CaF_2:Ce^{3+},Mn^{2+}$, $CaF_2:Ce^{3+},Tb^{3+}$, $CaF_2:Eu^{2+}$, $CaF_2:Mn^{2+}$, $CaGa_2O_4:Mn^{2+}$, $CaGa_4O_7:Mn^{2+}$, $CaGa_2S_4:Ce^{3+}$, $CaGa_2S_4:Eu^{2+}$, $CaGa_2S_4:Mn^{2+}$, $CaGa_2S_4:Pb^{2+}$, $CaGeO_3:Mn^{2+}$, $CaI_2:Eu^{2+}$ in $SiO_2$, $CaI_2:Eu^{2+},Mn^{2+}$ in $SiO_2$, $CaLaBO_4:Eu^{3+}$, $CaLaB_3O_7:Ce^{3+},Mn^{2+}$, $Ca_2La_2BO_{6.5}:Pb^{2+}$, $Ca_2MgSi_2O_7$, $Ca_2MgSi_2O_7:Ce^{3+}$, $CaMgSi_2O_6:Eu^{2+}$, $Ca_3MgSi_2O_8:Eu^{2+}$, $Ca_2MgSi_2O_7:Eu^{2+}$, $CaMgSi_2O_6:Eu^{2+},Mn^{2+}$, $Ca_2MgSi_2O_7:Eu^{2+},Mn^{2+}$, $CaMoO_4$, $CaMoO_4:Eu^{3+}$, $CaO:Bi^{3+}$, $CaO:Cd^{2+}$, $CaO:Cu^+$, $CaO:Eu^{3+}$, $CaO:Eu^{3+},Na^+$, $CaO:Mn^{2+}$, $CaO:Pb^{2+}$, $CaO:Sb^{3+}$, $CaO:Sm^{3+}$, $CaO:Tb^{3+}$, $CaO:Tl$, $CaO:Zn^{2+}$, $Ca_2P_2O_7:Ce^{3+}$, $\alpha$-$Ca_3(PO_4)_2:Ce^{3+}$, $\beta$-$Ca_3(PO_4)_2:Ce^{3+}$, $Ca_5(PO_4)_3Cl:Eu^{2+}$, $Ca_5(PO_4)3Cl:Mn^{2+}$, $Ca_5(PO_4)_3Cl:Sb^{3+}$, $Ca_5(PO_4)_3Cl:Sn^{2+}$, $\beta$-$Ca_3(PO_4)_2:Eu^{2+},Mn^{2+}$, $Ca_5(PO_4)_3F:Mn^{2+}$, $Ca_5(PO_4)_3F:Sb^{3+}$, $Ca_5(PO_4)_3F:Sn^{2+}$, $\alpha$-$Ca_3(PO_4)_2:Eu^{2+}$, $\beta$-$Ca_3(PO_4)_2:Eu^{2+}$, $Ca_2P_2O_7:Eu^{2+}$, $Ca_2P_2O_7:Eu^{2+},Mn^{2+}$, $CaP_2O_6:Mn^{2+}$, $\alpha$-$Ca_3(PO_4)_2:Pb^{2+}$, $\alpha$-$Ca_3(PO_4)_2:Sn^{2+}$, $\beta$-$Ca_3(PO_4)_2:Sn^{2+}$, $\beta$-$Ca_2P_2O_7:Sn,Mn$, $\alpha$-$Ca_3(PO_4)_2:Tr$, $CaS:Bi^{3+}$, $CaS:Bi^{3+},Na$, $CaS:Ce^{3+}$, $CaS:Eu^{2+}$, $CaS:Cu^+,Na^+$, $CaS:La^{3+}$, $CaS:Mn^{2+}$, $CaSO_4:Bi$, $CaSO_4:Ce^{3+}$, $CaSO_4:Ce^{3+},Mn^{2+}$, $CaSO_4:Eu^{2+}$, $CaSO_4:Eu^{2+},Mn^{2+}$, $CaSO_4:Pb^{2+}$, $CaS:Pb^{2+}$, $CaS:Pb^{2+},Cl$, $CaS:Pb^{2+},Mn^{2+}$, $CaS:Pr^{3+},Pb^{2+},Cl$, $CaS:Sb^{3+}$, $CaS:Sb^{3+},Na$, $CaS:Sm^{3+}$, $CaS:Sn^{2+}$, $CaS:Sn^{2+},F$, $CaS:Tb^{3+}$, $CaS:Tb^{3+},Cl$, $CaS:Y^{3+}$, $CaS:Yb^{2+}$, $CaS:Yb^{2+},Cl$, $CaSc_2O_4:Ce$, $Ca_3(Sc,Mg)_2Si_3O_{12}:Ce$, $CaSiO_3:Ce^{3+}$, $Ca_3SiO_4Cl_2:Eu^{2+}$, $Ca_3SiO_4Cl_2:Pb^{2+}$, $CaSiO_3:Eu^{2+}$, $Ca_3SiO_5:Eu^{2+}$, $(Ca,Sr)_3SiO_5:Eu^{2+}$, $(Ca,Sr)3MgSi_2O_8:Eu^{2+}$, $(Ca,Sr)3MgSi_2O_8:Eu^{2+},Mn^{2+}$, $CaSiO_3:Mn^{2+},Pb$, $CaSiO_3:Pb^{2+}$, $CaSiO_3:Pb^{2+},Mn^{2+}$, $CaSiO_3:Ti^{4+}$, $CaSr_2(PO_4)_2:Bi^{3+}$, $\beta$-$(Ca,Sr)_3(PO_4)_2:Sn^{2+}Mn^{2+}$, $CaTi_{0.9}Al_{0.1}O_3:Bi^{3+}$, $CaTiO_3:Eu^{3+}$, $CaTiO_3:Pr^{3+}$, $Ca_5(VO_4)_3Cl$, $CaWO_4$, $CaWO_4:Pb^{2+}$, $CaWO_4:W$, $Ca_3WO_6:U$, $CaYAlO_4:Eu^{3+}$, $CaYBO_4:Bi^{3+}$, $CaYBO_4:Eu^{3+}$, $CaYB_{0.8}O_{3.7}:Eu^{3+}$, $CaY_2ZrO_6:Eu^{3+}$, $(Ca,Zn,Mg)_3(PO_4)_2:Sn$, $(Ce,Mg)BaAl_{11}O_{13}:Ce$, $(Ce,Mg)SrAl_{11}O_{18}:Ce$, $CeMgAl_{11}O_{19}:Ce:Tb$, $Cd_2B_6O_{11}:Mn^{2+}$, $CdS:Ag^+,Cr$, $CdS:In$, $CdS:In$, $CdS:In,Te$, $CdS:Te$, $CdWO_4$, $CsF$, $CsI$, $CsI:Na^+$, $CsI:Tl$, $(ErCl_3)_{0.25}(BaCl_2)_{0.75}$, $GaN:Zn$, $Gd_3Ga_5O_{12}:Cr^{3+}$, $Gd_3Ga_5O_{12}:Cr,Ce$, $GdNbO_4:Bi^{3+}$, $Gd_2O_2S:Eu^{3+}$, $Gd_2O_2Pr^{3+}$, $Gd_2O_2S:Pr,Ce,F$, $Gd_2O_2S:Tb^{3+}$, $Gd_2SiO_5:Ce^{3+}$, $KAl_{11}O_{17}:Tl^+$, $KGa_{11}O_{17}:Mn^{2+}$, $K_2La_2Ti_3O_{10}:Eu$, $KMgF_3:Eu^{2+}$, $KMgF_3:Mn^{2+}$, $K_2SiF_6:Mn^{4+}$, $LaAl_3B_4O_{12}:Eu^{3+}$, $LaAlB_2O_6:Eu^{3+}$, $LaAlO_3:Eu^{3+}$, $LaAlO_3:Sm^{3+}$, $LaAsO_4:Eu^{3+}$, $LaBr_3:Ce^{3+}$, $LaBO_3:Eu^{3+}$, $LaCl_3:Ce^{3+}$, $La_2O_3:Bi^{3+}$, $LaOBr:Tb^{3+}$, $LaOBr:Tm^{3+}$, $LaOCl:Bi^{3+}$, $LaOCl:Eu^{3+}$, $LaOF:Eu^{3+}$, $La_2O_3:Eu^{3+}$, $La_2O_3:Pr^{3+}$, $La_2O_2S:Tb^{3+}$, $LaPO_4:Ce^{3+}$, $LaPO_4:Eu^{3+}$, $LaSiO_3Cl:Ce^{3+}$, $LaSiO_3Cl:Ce^{3+},Tb^{3+}$, $LaVO_4:Eu^{3+}$, $La_2W_3O_{12}:Eu^{3+}$, $LiAlF_4:Mn^{2+}$, $LiAl_5O_8:Fe^{3+}$, $LiAlO_2:Fe^{3+}$, $LiAlO_2:Mn^{2+}$, $LiAl_5O_8:Mn^{2+}$, $Li_2CaP_2O_7:Ce^{3+},Mn^{2+}$, $LiCeBa_4Si_4O_{14}:Mn^{2+}$, $LiCeSrBa_3Si_4O_{14}:Mn^{2+}$, $LiInO_2:Eu^{3+}$, $LiInO_2:Sm^{3+}$, $LiLaO_2:Eu^{3+}$, $LuAlO_3:Ce^{3+}$, $(Lu,Gd)_2SiO_5:Ce^{3+}$, $Lu_2SiO_5:Ce^{3+}$, $Lu_2Si_2O_7:Ce^{3+}$, $LuTaO_4:Nb^{5+}$, $Lu_{1-x}Y_xAlO_3Ce^{3+}$ (mit $0 \leq x \leq 1$), $(Lu,Y)_3(Al,Ga,Sc)_5O_{12}:Ce,MgAl_2O_4:Mn^{2+}$, $MgSrAl_{10}O_{17}:Ce$, $MgB_2O_4:Mn^{2+}$, $MgBa_2(PO_4)_2:Sn^{2+}$, $MgBa_2(PO_4)_2:U$, $MgBaP_2O_7:Eu^{2+}$, $MgBaP_2O_7:Eu^{2+},Mn^{2+}$, $MgBa_3Si_2O_8:Eu^{2+}$, $MgBa(SO_4)_2:Eu^{2+}$, $Mg_3Ca_3(PO_4)_4:Eu^{2+}$, $MgCaP_2O_7:Mn^{2+}$, $Mg_2Ca(SO_4)_3:Eu^{2+}$, $Mg_2Ca(SO_4)_3:Eu^{2+},Mn2$, $MgCeAl_nO_{19}:Tb^{3+}$, $Mg_4(F)GeO_6:Mn^{2+}$, $Mg_4(F)(Ge,Sn)O_6:Mn^{2+}$, $MgF_2:Mn^{2+}$, $MgGa_2O_4:Mn^{2+}$, $Mg_8Ge_2O_{11}F_2:Mn^{4+}$, $MgS:Eu^{2+}$, $MgSiO_3:Mn^{2+}$, $Mg_2SiO_4:Mn^{2+}$, $Mg_3SiO_3F4:Ti^{4+}$, $MgSO_4:Eu^{2+}$, $MgSO_4:Pb^{2+}$, $MgSrBa_2Si_2O_7:Eu^{2+}$, $MgSrP_2O_7:Eu^{2+}$, $MgSr_5(PO_4)_4:Sn^{2+}$, $MgSr_3Si_2O_8:Eu^{2+},Mn^{2+}$, $Mg_2Sr(SO_4)_3:Eu^{2+}$, $Mg_2TiO_4:Mn^{4+}$, $MgWO_4$, $MgYBO_4:Eu^{3+}$, $M_2MgSi_2O_7:Eu^{2+}$ (M = Ca, Sr, und/oder Ba), $M_2MgSi_2O_7:Eu^{2+},Mn^{2+}$ (M = Ca, Sr, und/oder Ba), $M_2MgSi_2O_7:Eu^{2+},Zr^{4+}$ (M = Ca, Sr, und/oder Ba), $M_2MgSi_2O_7:Eu^{2+},Mn^{2+},Zr^{4+}$ (M = Ca, Sr, und/oder Ba), $Na_3Ce(PO_4)_2:Tb^{3+}$, $Na_{1.23}K_{0.42}Eu_{0.12}TiSi_4O_{11}:Eu^{3+}$, $Na_{1.23}K_{0.42}Eu_{0.12}TiSi_5O_{13}\cdot xH_2O:Eu^{3+}$, $Na_{1.29}K_{0.46}Er_{0.08}TiSi_4O_{11}:Eu^{3+}$, $Na_2Mg_3Al_2Si_2O_{10}:Tb$, $Na(Mg_{2-x}Mn_x)LiSi_4O_{10}F_2:Mn$ (mit $0 \leq x \leq 2$), $NaYF_4:Er^{3+}$, $Yb^{3+}$, $NaYO_2:Eu^{3+}$, $P46(70\%) + P47 (30\%)$, $\beta$-$SiAlON:Eu$, $SrAl_{12}O_{19}:Cr^{3+}$, $Mn^{2+}$, $SrAl_2O_4:Eu^{2+}$, $SrAl_4O_7:Eu^{3+}$, $SrAl_{12}O_{19}:Eu^{2+}$, $SrAl_2S_4:Eu^{2+}$, $Sr_2B_5O_9Cl:Eu^{2+}$, $SrB_4O_7:Eu^{2+}(F,Cl,Br)$, $SrB_4O_7:Pb^{2+}$, $SrB_4O_7:Pb^{2+}$, $Mn^{2+}$, $SrB_8O_{13}:Sm^{2+}$, $Sr_xBa_yCl_zAl_2O_{4-z/2}$: $Mn^{2+}$, $Ce^{3+}$, $SrBaSiO_4:Eu^{2+}$, $(Sr,Ba)_3SiO_5:Eu$, $(Sr,Ca)Si_2N_2O_2:Eu$, $Sr(Cl,Br,I)2:Eu^{2+}$ in $SiO_2$, $SrCl_2:Eu^{2+}$ in $SiO_2$, $Sr_5Cl(PO_4)_3:Eu$, $Sr_wF_xB_4O_{6.5}:Eu^{2+}$, $Sr_wF_xB_yO_z:Eu^{2+},Sm^{2+}$, $SrF_2:Eu^{2+}$, $SrGa_{12}O_{19}:Mn^{2+}$, $SrGa_2S_4:Ce^{3+}$, $SrGa_2S_4:Eu^{2+}$, $Sr_{2-y}Ba_ySiO_4:Eu$ (wobei $0 \leq y \leq 2$), $SrSi_2O_2N_2:Eu$, $SrGa_2S_4:Pb^{2+}$, $SrIn_2O_4:Pr^{3+}$, $Al^{3+}$, $(Sr,Mg)_3(PO_4)_2:Sn$, $SrMgSi_2O_6:Eu^{2+}$, $Sr_2MgSi_2O_7:Eu^{2+}$, $Sr_3MgSi_2O_8:Eu^{2+}$, $SrMoO_4:U$, $SrO\cdot3B_2O_3:Eu^{2+},Cl$, $\beta$-$SrO\cdot3B_2O_3:Pb^{2+}$, $\beta$-$SrO\cdot3B_2O_3:Pb^{2+},Mn^{2+}$, $\alpha$-$SrO\cdot3B_2O_3:Sm^{2+}$, $Sr_6P_5BO_{20}:Eu$, $Sr_5(PO_4)_3Cl:Eu^{2+}$, $Sr_5(PO_4)_3Cl:Eu^{2+},Pr^{3+}$, $Sr_5(PO_4)_3Cl:Mn^{2+}$, $Sr_5(PO_4)_3Cl:Sb^{3+}$, $Sr_2P_2O_7:Eu^{2+}$, $\beta$-$Sr_3(PO_4)_2:Eu^{2+}$, $Sr_5(PO_4)_3F:Mn^{2+}$, $Sr_5(PO_4)_3F:Sb^{3+}$, $Sr_5(PO_4)_3F:Sb^{3+},Mn^{2+}$, $Sr_5(PO_4)_3F:Sn^{2+}$, $Sr_2P_2O_7:Sn^{2+}$, $\beta$-$Sr_3(PO_4)_2:Sn^{2+}$, $\beta$-$Sr_3(PO_4)_2:Sn^{2+},Mn^{2+}(Al)$, $SrS:Ce^{3+}$, $SrS:Eu^{2+}$, $SrS:Mn^{2+}$, $SrS:Cu^+,Na$, $SrSO_4:Bi$, $SrSO_4:Ce^{3+}$, $SrSO_4:Eu^{2+}$, $SrSO_4:Eu^{2+},Mn^{2+}$, $Sr_5Si_4O_{10}Cl_6:Eu^{2+}$, $Sr_2SiO_4:Eu^{2+}$, $Sr_3SiO_5:Eu^{2+}$, $(Sr,Ba)_3SiO_5:Eu^{2+}$, $SrTiO_3:Pr^{3+}$, $SrTiO_3:Pr^{3+},Al^{3+},SrY_2O_3:Eu^{3+}$, $ThO_2:Eu^{3+}$, $ThO_2:Pr^{3+}$, $ThO_2:Tb^{3+}$, $YAl_3B_4O_{12}:Bi^{3+}$, $YAl_3B_4O_{12}:Ce^{3+}$, $YAl_3B_4O_{12}:Ce^{3+},Mn$, $YAl_3B_4O_{12}:Ce^{3+},Tb^{3+}$, $YAl_3B_4O_{12}:Eu^{3+}$, $YAl_3B_4O_{12}:Eu^{3+},Cr^{3+}$, $YAl_3B_4O_{12}:Th^{4+},Ce^{3+},Mn^{2+}$, $YAlO_3:Ce^{3+}$, $Y_3Al_5O_{12}:Ce^{3+}$, $Y_3Al_5O_{12}:Cr^{3+}$, $YAlO_3:Eu^{3+}$, $Y_3Al_5O_{12}:Eu^{3r}$, $Y_4Al_2O_9:Eu^{3+}$, $Y_3Al_5O_{12}:Mn^{4+}$, $YAlO_3:Sm^{3+}$, $YAlO_3:Tb^{3+}$, $Y_3Al_5O_{12}:Tb^{3+}$, $YAsO_4:Eu^{3+}$, $YBO_3:Ce^{3+}$, $YBO_3:Eu^{3+}$, $YF_3:Er^{3+},Yb^{3+}$, $YF_3:Mn^{2+}$, $YF_3:Mn^{2+},Th^{4+}$, $YF_3:Tm^{3+},Yb^{3+}$, $(Y,Gd)BO_3:Eu$, $(Y,Gd)BO_3:Tb$, $(Y,Gd)_2O_3:Eu^{3+}$, $Y_{1.34}Gd_{0.60}O_3(Eu,Pr)$, $Y_2O_3:Bi^{3+}$, $YOBr:Eu^{3+}$, $Y_2O_3:Ce$, $Y_2O_3:Er^{3+}$, $Y_2O_3:Eu^{3+}$, $Y_2O_3:Ce^{3+},Tb^{3+}$, $YOCl:Ce^{3+}$, $YOCl:Eu^{3+}$, $YOF:Eu^{3+}$, $YOF:Tb^{3+}$, $Y_2O_3:Ho^{3+}$, $Y_2O_2S:Eu^{3+}$, $Y_2O_2S:Pr^{3+}$, $Y_2O_2S:Tb^{3+}$, $Y_2O_3:Tb^{3+}$, $YPO_4:Ce^{3+}$, $YPO_4:Ce^{3+},Tb^{3+}$, $YPO_4:Eu^{3+}$, $YPO_4:Mn^{2+},Th^{4+}$, $YPO_4:V^{5+}$, $Y(P,V)O_4:Eu$, $Y_2SiO_5:Ce^{3+}$, $YTaO_4$, $YTaO_4:Nb^{5+}$, $YVO_4:Dy^{3+}$, $YVO_4:Eu^{3+}$, $ZnAl_2O_4:Mn^{2+}$, $ZnB_2O_4:Mn^{2+}$, $ZnBa_2S_3:Mn^{2+}$, $(Zn,Be)_2SiO_4:Mn^{2+}$, $Zn_{0.4}Cd_{0.6}S:Ag$, $Zn_{0.6}Cd_{0.4}S:Ag$, $(Zn,Cd)S:Ag,Cl$, $(Zn,Cd)S:Cu$, $ZnF_2:Mn^{2+}$, $ZnGa_2O_4$, $ZnGa_2O_4:Mn^{2+}$, $ZnGa_2S_4:Mn^{2+}$, $Zn_2GeO_4:Mn^{2+}$, $(Zn,Mg)F_2:Mn^{2+}$, $ZnMg_2(PO_4)_2:Mn^{2+}$, $(Zn,Mg)_3(PO_4)_2:Mn^{2+}$, $ZnO:Al^{3+},Ga^{3+}$, $ZnO:Bi^{3+}$, $ZnO:Ga^{3+}$, $ZnO:Ga$, $ZnO$-$CdO:Ga$, $ZnO:S$, $ZnO:Se$, $ZnO:Zn$, $ZnS:Ag^+,Cl^-$, $ZnS:Ag,Cu,Cl$, $ZnS:Ag,Ni$, $ZnS:Au,In$, $ZnS$-$CdS$ (25-75), $ZnS$-$CdS$ (50-50), $ZnS$-$CdS$ (75-25), $ZnS$-$CdS:Ag,Br,Ni$, $ZnS$-$CdS:Ag^+,Cl$, $ZnS$-

CdS:Cu,Br, ZnS-CdS:Cu,I, ZnS:Cl⁻, ZnS:Eu²⁺, ZnS:Cu, ZnS:Cu⁺,Al³⁺, ZnS:Cu⁺,Cl⁻, ZnS:Cu,Sn, ZnS:Eu²⁺, ZnS:Mn²⁺, ZnS:Mn,Cu, ZnS:Mn²⁺,Te²⁺, ZnS:P, ZnS:P³⁻,Cl⁻, ZnS:Pb²⁺, ZnS:Pb²⁺,Cl⁻, ZnS:Pb,Cu, $Zn_3(PO_4)_2$:Mn²⁺, $Zn_2SiO_4$:Mn²⁺, $Zn_2SiO_4$:Mn²⁺,As⁵⁺, $Zn_2SiO_4$:Mn,Sb₂O₂, $Zn_2SiO_4$:Mn²⁺,P, $Zn_2SiO_4$:Ti⁴⁺, ZnS:Sn²⁺, ZnS:Sn,Ag, ZnS:Sn²⁺,Li⁺, ZnS:Te,Mn, ZnS-ZnTe:Mn²⁺, ZnSe:Cu⁺,Cl und ZnWO₄.

Das lichtkonvertierende Material oder die lichtkonvertierende Mischung gemäß der vorliegenden Erfindung kann zur teilweisen oder vollständigen Konversion von ultraviolettem und/oder blauem Licht in Licht mit einer größeren Wellenlänge, wie beispielsweise grünes oder rotes Licht, verwendet werden. Ein weiterer Gegenstand der vorliegenden Erfindung ist somit die Verwendung des lichtkonvertierenden Materials bzw. der lichtkonvertierenden Mischung in einer Lichtquelle. Besonders bevorzugt ist die Lichtquelle eine LED, insbesondere eine phosphorkonvertierte LED, kurz pc-LED. Hierbei ist es besonders bevorzugt, dass das lichtkonvertierende Material mit mindestens einem weiteren lichtkonvertierenden Material und/oder einem oder mehreren Konversionsleuchtstoffen gemischt wird und so eine lichtkonvertierende Mischung bildet, die insbesondere weißes Licht oder Licht mit einem bestimmten Farbpunkt (Color-on-demand-Prinzip) emittiert. Unter "Color-on-demand-Prinzip" versteht man die Realisierung von Licht eines bestimmten Farbpunktes mit einer pc-LED unter Einsatz eines oder mehrerer lichtemittierender Materialien und/oder Konversionsleuchtstoffe.

Ein weiterer Gegenstand der vorliegenden Erfindung ist somit eine Lichtquelle, die eine Primärlichtquelle und mindestens ein erfindungsgemäßes lichtkonvertierendes Material oder mindestens eine erfindungsgemäße lichtkonvertierenden Mischung umfasst. Auch hier ist es insbesondere bevorzugt, dass die Lichtquelle neben dem erfindungsgemäßen lichtkonvertierenden Material noch ein weiteres erfindungsgemäßes lichtkonvertierendes Material, Lumineszenzmaterial und/oder Halbleiter Nanopartikel umfasst, so dass die Lichtquelle vorzugsweise weißes Licht oder Licht mit einem bestimmten Farbpunkt emittiert.

Die erfindungsgemäße Lichtquelle ist vorzugsweise eine pc-LED, die eine Primärlichtquelle und ein lichtkonvertierendes Material oder eine lichtkonvertierende Mischung enthält. Das lichtkonvertierende Material oder die lichtkonvertierende Mischung wird vorzugsweise in Form einer Schicht ausgebildet, wobei die Schicht eine Vielzahl von Teilschichten umfassen kann, wobei jede der Teilschichten eine anderes lichtkonvertierendes Material oder eine andere lichtkonvertierende Mischung enthalten kann. Somit kann die Schicht entweder ein einziges lichtkonvertierendes Material oder eine einzige lichtkonvertierende Mischung oder eine Vielzahl von Teilschichten umfassen, wobei jede Teilschicht wiederum ein anderes lichtkonvertierendes Material oder eine andere lichtkonvertierende Mischung umfasst. Die Dicke der Schicht kann im Bereich von einigen Millimetern bis zu wenigen Mikrometern, vorzugsweise im Bereich zwischen 2 mm und 5 μm, liegen, je nach Teilchengröße des lichtkonvertierenden Materials bzw. der lichtkonvertierenden Mischung und der geforderten optischen Merkmale.

In einigen Ausführungsformen zur Modulation des Emissionsspektrums einer LED kann auf der Primärlichtquelle eine einzige Schicht oder eine Schicht mit Teilschichten gebildet werden. Die Schicht oder die Schicht mit Teilschichten kann entweder direkt auf der Primärlichtquelle angeordnet sein oder von der Primärlichtquelle durch Luft, Vakuum oder ein Füllmaterial beabstandet sein. Das Füllmaterial (beispielsweise Silicon oder Epoxy) kann als Wärmeisolierung und/oder als optische Streuschicht dienen. Die Modulation des Emissionsspektrums der Primärlichtquelle kann Beleuchtungszwecken dienen, um eine Lichtabgabe mit einem breiten Farbspektrum zu erzeugen, z.B. "weißes" Licht mit einem hohen Farbwiedergabeindex (color rendering index - CRI) und der gewünschten korrelierten Farbtemperatur (correlated color temperature - CCT). Die Lichtabgabe mit breitem Farbspektrum wird erzeugt, indem man einen Teil des ursprünglichen von der Primärlichtquelle erzeugten Lichtes in längerwelliges Licht umwandelt. Eine Verstärkung der Intensität von rot ist wichtig, um "wärmeres" Licht mit niedrigerer CCT (z.B. 2700-3500K) zu erhalten, aber auch ein "Glätten" spezifischer Bereiche im Spektrum, wie beispielsweise im Übergang von blau auf grün, kann den CRI ebenfalls verbessern. Die Modulation der LED-Beleuchtung kann auch für optische Anzeigezwecke verwendet werden.

Das erfindungsgemäße lichtkonvertierende Material oder die erfindungsgemäße lichtkonvertierende Mischung kann in einem Vergussmaterial, wie beispielsweise einem Glas, Silicon-, Silazan- oder Epoxy-Harz, dispergiert sein oder als keramisches Material ausgebildet sein. Das Vergussmaterial ist ein lichtdurchlässiges Matrixmaterial, das das erfindungsgemäße lichtkonvertierende Material bzw. die erfindungsgemäße lichtkonvertierende Mischungen einschließt. Bevorzugte Beispiele des Vergussmaterials, die keineswegs als einschränkend zu verstehen sind, sind weiter oben genannt. Vorzugsweise wird das lichtkonvertierende Material oder die lichtkonvertierende Mischung in einem Verhältnis von 3 bis 80 Gew.-%, bezogen auf das Vergussmaterial, eingesetzt, je nach den gewünschten optischen Eigenschaften und dem Aufbau der Anwendung.

In einer bevorzugten Ausführungsform ist das erfindungsgemäße lichtkonvertierende Material oder die erfindungsgemäße lichtkonvertierende Mischung direkt auf der Primärlichtquelle angeordnet.

In einer alternativen bevorzugten Ausführungsform ist das erfindungsgemäße lichtkonvertierende Material oder die erfindungsgemäße lichtkonvertierende Mischung auf einem Trägermaterial von der Primärlichtquelle entfernt angeordnet (sog. Remote-Phosphor-Prinzip).

Die Primärlichtquelle der erfindungsgemäßen Lichtquelle kann ein Halbleiterchip, eine lumineszente Lichtquelle, wie ZnO, eine sogenanntes TCO (Transparent Conducting Oxide), eine ZnSe oder SiC basierende Anordnung, eine auf einer organischen Licht-emittierenden Schicht basierende Anordnung (OLED) oder eine Plasma- oder Entladungsquelle sein, am stärksten bevorzugt ein Halbleiterchip. Ist die Primärlichtquelle ein Halbleiterchip, so handelt es sich vorzugsweise um ein lumineszentes Indium-Aluminium-Gallium-Nitrid (InAlGaN), wie es im Stand der Technik bekannt ist. Dem Fachmann sind mögliche Formen von derartigen Primärlichtquellen bekannt. Weiterhin geeignet sind Laser als Lichtquelle.

Das erfindungsgemäße lichtkonvertierende Material oder die erfindungsgemäße lichtkonvertierende Mischung kann zum Einsatz in Lichtquellen, insbesondere pc-LEDs, in beliebigen äußeren Formen, wie beispielsweise sphärischen Partikeln, Plättchen sowie strukturierte Materialien und Keramiken, überführt werden. Diese Formen werden unter dem Begriff "Formkörper" zusammengefasst. Folglich handelt es sich bei den Formkörpern um lichtkonvertierende Formkörper.

Ein weiterer Gegenstand der vorliegenden Erfindung ist ein Verfahren zur Herstellung einer Lichtquelle, wobei das lichtkonvertierende Material oder die lichtkonvertierende Mischung in Form eines Films durch Spin-Coating oder Sprühbeschichtung oder in Form einer Folie als Laminat auf die Primärlichtquelle oder das Trägermaterial aufgebracht wird.

Ein weiterer Erfindungsgegenstand ist eine Beleuchtungseinheit, die mindestens eine erfindungsgemäße Lichtquelle enthält. Die Verwendung der Beleuchtungseinheit unterliegt keiner besonderen Einschränkung. So kann die Beleuchtungseinheit beispielsweise in optischen Anzeigevorrichtungen, insbesondere Flüssigkristallanzeigevorrichtungen (LC-Displays), mit einer Hintergrundbeleuchtung eingesetzt werden. Daher ist auch eine derartige Anzeigevorrichtung Gegenstand der vorliegenden Erfindung. In der erfindungsgemäßen Beleuchtungseinheit erfolgt die optische Ankopplung zwischen dem lichtkonvertierenden Material oder der lichtkonvertierenden Mischung und der Primärlichtquelle (insbesondere Halbleiterchips) vorzugsweise durch eine lichtleitende Anordnung oder Vorrichtung. Dadurch ist es möglich, dass an einem zentralen Ort die Primärlichtquelle installiert wird und diese mittels lichtleitender Vorrichtungen, wie beispielsweise lichtleitenden Fasern, an das lichtkonvertierende Material oder die lichtkonvertierende Mischung optisch angekoppelt ist. Auf diese Weise lassen sich den Beleuchtungswünschen angepasste Leuchten bestehend aus einem oder mehreren unterschiedlichen lichtkonvertierenden Materialien oder Mischungen, die zu einem Leuchtschirm angeordnet sein können, und einem Lichtleiter, der an die Primärlichtquelle angekoppelt ist, realisieren. Dadurch ist es möglich, eine starke Primärlichtquelle an einem für die elektrische Installation günstigen Ort zu platzieren und ohne weitere elektrische Verkabelung, nur durch Verlegung von Lichtleitern an beliebigen Orten, Leuchten aus lichtkonvertierenden Materialien oder Mischungen, die an die Lichtleiter gekoppelt sind, zu installieren.

Die folgenden Beispiele und Figuren sollen die vorliegende Erfindung verdeutlichen. Sie sind jedoch keinesfalls als einschränkend zu betrachten.

Beispiele

Alle Emissionsspektren wurden in einer Ulbricht'schen Kugel kombiniert mit einem OceanOptics QE Pro Spektrometer aufgenommen. Als Anregungslichtquelle zur Aufnahme von Pulverspektren dient eine Halogen-Kaltlichtquelle mit Monochromator und die anregungswellenlängenabhängige Intensität wurde mit einem Fotomultiplier aufgezeichnet. Die getesteten LEDs werden mittels eines Keithley-Sourcemeters betrieben (für die hier gezeigten Versuche wurde die 5630 LED mit -450 nm Chipwellenlänge bei 60 mA verwendet).

Die Aufnahme der Korngrößenverteilungen wurde mit einem Beckman Coulter Multisizer III in isotonischer Kochsalzlösung vorgenommen. Es wurden jeweils > 100.000 Teilchen vermessen.

Ausführungsbeispiele für die Herstellung des lichtkonvertierenden Materials

ORANGE oder ROT:

**Beispiel 1:** 5 g eines orangenen pulvrigen, $Eu^{2+}$-aktiviertem Silikat-Leuchtstoffs (($Ba,Sr)_3SiO_5$ mit $\lambda_{em,max} = 600$ nm) werden in einem 100 ml Kolben in 15 ml Toluol suspendiert. Zur Suspension werden 50 mg einer roten Nanodot-Suspension (20 Gew.-% CdSe/CdS- basierte-Nanohalbleiterkristalle mit 625 nm Peakemissionswellenlänge in Toluol) gegeben. Diese Suspension wird für 1 h gerührt. Am Rotationsverdampfer wird das Lösungsmittel unter Vakuum bei 50 °C Wasserbadtemperatur vorsichtig entfernt. Das behandelte Silikatpulver (QD rot 1) wird für weitere 1,5 h unter Vakuum bei 50 °C Wasserbadtemperatur getrocknet.

**Beispiel 2:** 5 g eines orangenen pulvrigen, $Eu^{2+}$-aktiviertem Silikat-Leuchtstoffs (($Ba,Sr)_3SiO_5$ mit $\lambda_{em,max} = 600$ nm) werden in einem 100 ml Kolben in 15 ml Toluol suspendiert. Zur Suspension werden 1,74 g einer roten Nanodot-Suspension (10 Gew.-% InP-ZnS-basierte-Nanohalbleiterkristalle mit 648 nm Peakemissionswellenlänge in Toluol) gegeben. Diese Suspension wird für 2,5 h gerührt gemischt. Am Rotationsverdampfer wird das Lösungsmittel unter Vakuum bei 50 °C Wasserbadtemperatur vorsichtig entfernt. Zur vollständigen Entfernung des Lösungsmittels wird das behandelte Silikat (QD rot 2) für zwei weitere Stunden unter Vakuum bei 50 °C am Rotationsverdampfer belassen.

**Beispiel 3:** 2,5 g eines roten pulvrigen, $Eu^{2+}$-aktiviertem Nitrid-Leuchtstoffs ($CaAlSiN_3$ mit $\lambda_{em,max}$ = 613 nm) werden in einem 100 ml Kolben in 15 ml Toluol suspendiert. Zur Suspension werden 250 mg einer roten Nanodot-Suspension (20 Gew.-% CdSe/CdS-basierte-Nanohalbleiterkristalle mit 625 nm Peakemissionswellenlänge in Toluol) gegeben. Diese Suspension wird für 1 h gerührt. Am Rotationsverdampfer wird das Lösungsmittel unter Vakuum bei 50 °C Wasserbadtemperatur vorsichtig entfernt. Zur vollständigen Entfernung des Lösungsmittels wird das behandelte Silikat (QD rot 3) für zwei weitere Stunden unter Vakuum bei 50 °C am Rotationsverdampfer belassen.

**Beispiel 4:** 5 g eines orangenen pulvrigen, $Eu^{2+}$-aktiviertem Silikat-Leuchtstoffs (($Ba,Sr)_3SiO_5$ mit $\lambda_{em,max}$ = 585 nm) werden in einem 100 ml Kolben in 15 ml Ethanol suspendiert. Zur Suspension werden 650 mg einer roten Nanodot-Suspension (15 Gew.-% CdSe/CdS- basierte-Nanohalbleiterkristalle mit 627 nm Peakemissionswellenlänge in PGMEA) gegeben. Diese Suspension wird für 2,5 h gerührt. Am Rotationsverdampfer wird das Lösungsmittel unter Vakuum bei 50 °C Wasserbadtemperatur vorsichtig entfernt. Das behandelte Silikatpulver (QD rot 4) wird für weitere 2,5 h unter Vakuum bei 50 °C Wasserbadtemperatur getrocknet.

GRÜN:

**Beispiel 5:** 5 g eines grünen pulvrigen, $Eu^{2+}$-aktiviertem Silikat-Leuchtstoffs ($Ba,Sr)_2SiO_4$ mit $\lambda_{em,max}$ = 517 nm) werden in einem 100 ml Kolben in 15 ml Toluol suspendiert. Zur Suspension werden 600 mg einer grünen Nanodot-Suspension (20 Gew.-% CdSe/CdS/ZnS-basierte-Nanohalbleiterkristalle mit 525 nm Peakemissionswellenlänge in Toluol) gegeben. Diese Suspension wird für 2 h gerührt. Am Rotationsverdampfer wird das Lösungsmittel unter Vakuum bei 50 °C Wasserbadtemperatur vorsichtig entfernt. Das behandelte Silikatpulver (QD grün 1) wird für eine weitere Stunde unter Vakuum bei 50 °C Wasserbadtemperatur getrocknet.

**Beispiel 6:** 5 g eines grünen pulvrigen, $Eu^{2+}$-aktiviertem Silikats ($Ba,Sr)_2SiO_4$ mit $\lambda_{em,max}$ = 520 nm) werden in einem 100 ml Kolben in 15 ml Ethanol suspendiert. Zur Suspension werden 1,0 g einer grünen Nanodot-Suspension (10 Gew.-% CdSe/CdS/ZnS -basierte-Nanohalbleiterkristalle mit 525 nm Peakemissionswellenlänge in Wasser) gegeben. Diese Suspension wird für 4 h gerührt. Am Rotationsverdampfer wird das Lösungsmittel unter Vakuum bei 55 °C Wasserbadtemperatur vorsichtig entfernt. Das behandelte Silikatpulver (QD grün 2) wird für eine weitere Stunde unter Vakuum bei 55 °C Wasserbadtemperatur getrocknet.

**Beispiel 7:** 5 g eines grünen pulvrigen, $Eu^{2+}$-aktiviertem Silikat-Leuchtstoffs ($Ba,Sr)_2SiO_4$ mit $\lambda_{em,max}$ = 524 nm) werden in einem 100 ml Kolben in 15 ml Ethanol suspendiert. Zur Suspension werden 1,05 g einer grünen Nanodot-Suspension (10 Gew.-% CdSe/CdS/ZnS -basierte-Nanohalbleiterkristalle mit 525 nm Peakemissionswellenlänge in Wasser) gegeben. Diese Suspension wird für 3 h gerührt. Am Rotationsverdampfer wird das Lösungsmittel unter Vakuum bei 50 °C Wasserbadtemperatur vorsichtig entfernt. Das behandelte Silikatpulver (QD grün 3) wird für eine weitere Stunde unter Vakuum bei 50 °C Wasserbadtemperatur getrocknet.

**Beispiel 8:** 5 g eines grünen pulvrigen, $Eu^{2+}$-aktiviertem Silikat-Leuchtstoffs ($Ba,Sr)_2SiO_4$ mit $\lambda_{em,max}$ = 515 nm) werden in einem 100 ml Kolben in 15 ml Ethanol suspendiert. Zur Suspension werden 1,05 g einer grünen Nanodot-Suspension (10 Gew.-% CdSe/CdS/ZnS - basierte-Nanohalbleiterkristalle mit 525 nm Peakemissionswellenlänge in Wasser) gegeben. Diese Suspension wird für 1,5 h gerührt. Am Rotationsverdampfer wird das Lösungsmittel unter Vakuum bei 55 °C Wasserbadtemperatur vorsichtig entfernt. Das behandelte Silikatpulver (QD grün 4) wird für eine weitere Stunde unter Vakuum bei 55 °C Wasserbadtemperatur getrocknet.

**Beispiel 9:** 5 g eines grünen pulvrigen, $Eu^{2+}$-aktiviertem Silikat-Leuchtstoffs ($Ba,Sr)_2SiO_4$ mit $\lambda_{em,max}$ = 521 nm) werden in einem 100 ml Kolben in 15 ml Ethanol suspendiert. Zur Suspension werden 1,55 g einer grünen Nanodot-Suspension (10 Gew.-% CdSe/CdS/ZnS - basierte-Nanohalbleiterkristalle mit 525 nm Peakemissionswellenlänge in Wasser) gegeben. Diese Suspension wird für 1,5 h gerührt. Am Rotationsverdampfer wird das Lösungsmittel unter Vakuum bei 55 °C Wasserbadtemperatur vorsichtig entfernt. Das behandelte Silikatpulver (QD grün 5) wird für eine weitere Stunde unter Vakuum bei 55 °C Wasserbadtemperatur getrocknet.

GRÜN/ROT:

**Beispiel 10:** 5 g eines grünen pulvrigen, $Eu^{2+}$-aktiviertem Orthosilikat-Leuchtstoffs (($Sr,Ba)_2SiO_4$) mit $\lambda_{em,max}$ = 520 nm) werden in einem 100 ml Kolben in 15 ml Toluol suspendiert. Zur Suspension werden 82 mg einer roten Nanodot-Suspension (20 Gew.-% CdSe/CdS-basierte-Nanohalbleiterkristalle mit 625 nm Peakemissionswellenlänge in Toluol) und 416 mg einer grünen Nanodot-Suspension (20 Gew.-% CdSe/CdS/ZnS -Nanostäbchen mit 525 nm Peakemissionswellenlänge in Toluol) gegeben. Diese Suspension wird für 1 h gerührt. Am Rotationsverdampfer wird das Lösungsmittel unter Vakuum bei 50 °C Wasserbadtemperatur vorsichtig entfernt. Zur vollständigen Entfernung des Lösungsmittels wird das behandelte Silikat (QD rot/grün 1) für eine weitere Stunde unter Vakuum bei 50 °C am Rotationsverdampfer belassen.

**Beispiel 11:** 5 g eines grünen pulvrigen, $Eu^{2+}$-aktiviertem Orthosilikat-Leuchtstoffs (($Sr,Ba)_2SiO_4$) mit $\lambda_{em,max}$ = 520 nm) werden in einem 100 ml Kolben in 15 ml Toluol suspendiert. Zur Suspension werden 71 mg einer roten Nanodot-Suspension (20 Gew.-% CdSe/CdS-basierte-Nanohalbleiterkristalle mit 625 nm Peakemissionswellenlänge in Toluol) gegeben. Diese Suspension wird für 1 h gerührt. Am Rotationsverdampfer wird das Lösungsmittel unter Vakuum bei 50 °C Wasserbadtemperatur vorsichtig entfernt. Zur vollständigen Entfernung des Lösungsmittels wird das behandelte Silikat für eine weitere Stunde unter Vakuum bei 50 °C am Rotationsverdampfer belassen. Anschließend wird das behandelte Silikat in Ethanol 10 ml suspendiert und 810 mg einer grünen Nanodot-Suspension (10 Gew.-% CdSe/CdS/ZnS -basierte-Nanohalbleiterkristalle mit 525 nm Peakemissionswellenlänge in Wasser) zugegeben. Nach einer Stunde rühren bei Raumtemperatur wird das Lösungsmittel am Rotationsverdampfer unter Vakuum bei 50 °C Wasserbadtemperatur vorsichtig entfernt. Zur vollständigen Entfernung des Lösungsmittels wird das behandelte Silikat (QD rot/grün 2) für zwei weitere Stunden unter Vakuum bei 50 °C am Rotationsverdampfer belassen.

Referenzbeispiele

**Beispiel 12:** 5 g eines blauen pulvrigen $Eu^{2+}$-aktivierten Orthosilikat-Leuchtstoffs $((Sr,Ca)_3MgSi_2O_8)$ mit $\lambda_{em,max}$ = 466 nm) werden in einem 100 ml Kolben in 15 ml Ethanol suspendiert. Zur Suspension werden 1,05 g einer grünen Nanodot-Suspension (10 Gew.-% CdSe/CdS/ZnS -basierte-Nanohalbleiterkristalle mit 525 nm Peakemissionswellenlänge in Wasser) gegeben. Diese Suspension wird für 1,5 h gerührt. Am Rotationsverdampfer wird das Lösungsmittel unter Vakuum bei 55 °C Wasserbadtemperatur vorsichtig entfernt. Das behandelte Silikatpulver (QD grün 6) wird für eine weitere Stunde unter Vakuum bei 55 °C Wasserbadtemperatur getrocknet

**Beispiel 13:** 5 g eines orangenen pulvrigen $Eu^{2+}$-aktivierten Silikat-Leuchtstoffs $((Ba,Sr)_3SiO_5$ mit $\lambda_{em,max}$ = 585 nm) werden in einem 100 ml Kolben in 15 ml Ethanol suspendiert. Zur Suspension werden 1,05 g einer grünen Nanodot-Suspension (10 Gew.-% CdSe/CdS/ZnS -basierte-Nanohalbleiterkristalle mit 525 nm Peakemissionswellenlänge in Wasser) gegeben. Diese Suspension wird für 2,5 h gerührt. Am Rotationsverdampfer wird das Lösungsmittel unter Vakuum bei 50 °C Wasserbadtemperatur vorsichtig entfernt. Das behandelte Silikatpulver (QD grün 7) wird für weitere 2,5 h unter Vakuum bei 50 °C Wasserbadtemperatur getrocknet.

Die nachfolgende Tabelle 1 zeigt die in den Beispielen 1 bis 13 verwendeten Lumineszenzmaterialien sowie die Halbleiter-Nanopartikel (QD), wobei die Beispiele 2,4,10,11,12 und 13 nicht Teil der vorliegenden Erfindung sind. Angegeben sind die Peakwellenlängenmaxima $\lambda_{em,max}$ der verwendeten Lumineszenzmaterialien sowie die Peakwellenlängenmaxima $\lambda_{em,max}$ der verwendeten Halbleiter-Nanopartikel und Peakwellenlängenmaxima $\lambda_{em,max}$ und Halbwertsbreiten **FWHM** der Emissionen der hergestellten lichtkonvertierenden Materialien. Die Emission der verwendeten Halbleiter-Nanopartikel wurde, wie weiter oben beschrieben, in verdünnter Suspension vermessen. Die Peakwellenlängenmaxima $\lambda_{em,max}$ und Halbwertsbreiten FWHM der Emissionen der hergestellten lichtkonvertierenden Materialien wurden im Pulver vermessen und zeigen aufgrund von Reabsorptionseffekten eine langwellige Verschiebung in Bezug auf die reinen Halbleiter-Nanopartikel-Emissionen.

Tabelle 1

| Beispiel | $\lambda_{em,max}$ (Lumineszenz-material) | $\lambda_{em,max}$ (Halbleiter-Nanopartikel) | $\lambda_{max}$ / nm (Produkt) | FWHM / nm (Produkt) |
|---|---|---|---|---|
| | Nitrid (613 nm) | - | 613 | 72 |
| | Silikat (600 nm) | - | 600 | 78 |
| | Silikat (585 nm) | - | 585 | 67 |
| | Silikat (524 nm) | - | 524 | 64 |
| | Silikat (520 nm) | - | 520 | 65 |
| | Silikat (517 nm) | - | 517 | 63 |
| | Silikat (515 nm) | - | 515 | 63 |
| 1 | Silikat (600 nm) | Rot 1 (625 nm) | 625 | 33 |
| 2 | Silikat (600 nm) | Rot 2 (648 nm) | 648 | 75 |
| 3 | Nitrid (613 nm) | Rot 3 (625 nm) | 625 | 37 |
| 4 | Silikat (585 nm) | Rot 4 (627 nm) | 627 | 30 |
| 5 | Silikat (517 nm) | Grün 1 (525 nm) | 532 | 40 |
| 6 | Silikat (520 nm) | Grün 2 (525 nm) | 534 | 48 |
| 7 | Silikat (524 nm) | Grün 3 (525 nm) | 535 | 56 |
| 8 | Silikat (515 nm) | Grün 4 (525 nm) | 534 | 50 |
| 9 | Silikat (521 nm) | Grün 5 (525 nm) | 536 | 45 |
| 10 | Silikat (520 nm) | Rot (625 nm) / Grün 1 (525 nm) | 530 / 623 | 26 / 38 |

(fortgesetzt)

| Beispiel | $\lambda_{em,max}$ (Lumineszenz-material) | $\lambda_{em,max}$ (Halbleiter-Nanopartikel) | $\lambda_{max}$ / nm (Produkt) | FWHM / nm (Produkt) |
|---|---|---|---|---|
| 11 | Silikat (520 nm) | Rot (625 nm) / Grün 2 (525 nm) | 533 | 25 |
| | | | 621 | 49 |
| 12 | Silikat (466 nm) | Grün 6 (525 nm) | 466 | 44 |
| | | | 528 | 38 |
| 13 | Silikat (585 nm) | Grün 7 (525 nm) | 585 | 73 |

Vermessung der hergestellten lichtkonvertierenden Materialien

Von allen lichtkonvertierenden anfallenden Materialien wurde die relative spektrale Energieverteilung mittels eines Faseroptikspektrometers bei einer Anregungswellenlänge von 450 nm aufgenommen. Die relative spektrale Energieverteilung aller hergestellter Materialien (Emission) ist in den Figuren 1 bis 5 gezeigt.

LED-Evaluierung

Unbefüllte LEDs werden mit einem optischen Silicon (Dow Corning OE6550), in welchem genaue Mengen von roten und grünen Partikeln suspendiert sind, über einen Dispenser befüllt. Die Siliconsuspension wird mittels eines biaxialen Rotationsmischers hergestellt und folgend unter Vakuum entgast. Anschließend wird die LED im Trockenschrank bei 150°C für 1 h ausgehärtet und mittels einer Ulbricht'schen Kugel mit Faseroptikspektrometer hinsichtlich der resultierenden Lichtemission vermessen. Durch Variation der Gesamtmenge des Pulvers im Silicon wie auch der roten, gelben oder grünen Einzelkomponenten kann nahezu jeder Farbort im Farbdreieck erreicht werden.

Anstelle von Silicon können auch andere hochtransparente Materialien als Vergussmasse, zum Beispiel Epoxidharze, verwendet werden.

Weitere nützliche Vorteile der erfindungsgemäßen lichtkonvertierenden Materialien sind:

- Durch Reabsorption der effizienten Emission eines lumineszenten Materials, das im Bereich der Primärlichtquelle eine hohe Absorption besitzt, wird eine gesteigerte Effizienz der LED sowie ein deutlich verringerter Materialverbrauch in der LED ermöglicht. Dies wird durch Figur 7 verdeutlicht, wobei bei gleichem Farbpunkt der Verbrauch einer Suspension auf Basis von analog hergesteltem unaktiviertem Substrat um 67% steigt und gleichzeitig die Effizienz um 22% sinkt.

- Höhere Farbraumabdeckung als mit herkömmlichen Leuchtstoffen wie grünem β-SiAlON oder Orthosilikat in Kombination mit rotem Leuchtstoff $K_2SiF_6$ durch schmalere Emission möglich.

- Gleiches Sedimentationsverhalten über alle in der LED verwendeten Konversionsmaterialien gegeben, ggf. gezielt einstellbar und erhöhte Produktionsausbeute im LED-Herstellprozess.

- Einfach zu verwenden, da kein neues Produktionsequipment beim LED Hersteller benötigt wird.

- Anwender hat mehr Möglichkeiten die LED-Emission einzustellen im Vergleich zu herkömmlichen QD-Filmen (flexibler Einsatz, da Anwender nicht für jeden Farbort einen anderen Lichtkonverter verwenden muss).

- Erhöhte Helligkeit der LED, da die rote, schmalbandige Emission keine Energie im tiefen langwelligen Spektralbereich mit geringer Augenempfindlichkeit verschwendet.

- Vorhandene Coating-Technologien für Leuchtstoffe können angewendet werden; es sind keine zusätzlichen Barrierefilme notwendig.

**Patentansprüche**

1. Lichtkonvertierendes Material, umfassend ein Lumineszenzmaterial in Form von makroskopischen Teilchen und mindestens eine Art von Halbleiter-Nanopartikeln, wobei sich die Halbleiter-Nanopartikel auf der Oberfläche des Lumineszenzmaterials befinden, wobei die Teilchen mehrere der Halbleiter-Nanopartikel enthalten, **dadurch ge-**

**kennzeichnet, dass** die Emission der Halbleiter-Nanopartikel im Bereich der Emission des Lumineszenzmaterials liegt, wobei ein Maximum der Kern-Exziton-Absorptionsbande der Halbleiter-Nanopartikel und ein Emissionsmaximum des Lumineszenzmaterials maximal 50 nm auseinanderliegen, wobei eine Überlappung $A_{OL}$ zwischen der Emissionsbande des Lumineszenzmaterials und der Kern-Exziton-Absorptionsbande der Halbleiter-Nanopartikel mindestens 80 % bezogen auf die Gesamtfläche der Kern-Exziton-Anregungsbande $A_{ex}$, beträgt, sodass die folgende Gleichung gilt:

$$A_{OL} / A_{ex} * 100\ \% > 80\ \%$$

und wobei für das Emissionsmaximum $\lambda_{em,max}$ der Halbleiter-Nanopartikel und das Emissionsmaximum $\lambda_{em,max}$ des Lumineszenzmaterials die folgende Gleichung gilt:

$$0\ \text{nm} \leq$$
$$|\lambda_{em,max}(\text{Halbleiter-Nanopartikel}) - \lambda_{em,max}(\text{Lumineszenzmaterial})|$$
$$\leq 30\ \text{nm}.$$

2. Lichtkonvertierendes Material gemäß Anspruch 1, wobei die Emissionsbande der Halbleiter-Nanopartikel und die Emissionsbande des Lumineszenzmaterials ganz oder teilweise überlappen.

3. Lichtkonvertierendes Material gemäß Anspruch 1 oder 2, wobei das Lumineszenzmaterial ein Leuchtstoff ist.

4. Lichtkonvertierendes Material gemäß einem oder mehreren der Ansprüche 1 bis 3, **dadurch gekennzeichnet, dass** das Lumineszenzmaterial ein mit Eu(II), Ce(III), Mn(II), Mn(IV), Eu(III), Tb(III), Sm(III), Cr(III), Sn(II), Pb(II), Sb(III), Bi(III), Cu(I), oder Ag(I) aktivierter anorganischer Leuchtstoff ist, ausgewählt aus der Liste bestehend aus Metalloxiden, Silikaten und Halosilikaten, Phosphaten und Halophosphaten, Boraten, Haloboraten und Borosilikaten, Aluminaten, Gallaten und Alumosilikaten, Molybdaten und Wolframaten, Sulfaten, Sulfiden, Seleniden und Telluriden, Nitriden und Oxynitriden, SiAlONen, komplexen Metall-Sauerstoff-Verbindungen, Halogen-Verbindungen und Oxy-Verbindungen.

5. Lichtkonvertierendes Material gemäß einem oder mehreren der Ansprüche 1 bis 4, **dadurch gekennzeichnet, dass** die Halbleiter-Nanopartikel mindestens zwei verschiedene Halbleitermaterialien umfassen.

6. Lichtkonvertierendes Material gemäß Anspruch 5, **dadurch gekennzeichnet, dass** die Halbleitermaterialien ausgewählt sind aus Gruppe II-VI-Halbleitern, Gruppe III-V-Halbleitern, Gruppe IV-VI-Halbleitern, Gruppe I-III-VI$_2$-Halbleitern sowie aus Legierungen und/oder Kombinationen dieser Halbleiter, wobei die Halbleitermaterialien wahlweise mit einem oder mehreren Übergangsmetallen dotiert sein können.

7. Lichtkonvertierendes Material gemäß einem oder mehreren der Ansprüche 1 bis 6, **dadurch gekennzeichnet, dass** die Halbleiter-Nanopartikel in Form von Nanopunkten, Nanostäbchen, Nanoplättchen, Nanotetrapods, Nanopunkten in Nanostäbchen, Nanostäbchen in Nanostäbchen und/oder Nanopunkten in Nanoplättchen vorliegen.

8. Lichtkonvertierende Mischung, umfassend eines oder mehrere der lichtkonvertierenden Materialien gemäß einem oder mehreren der Ansprüche 1 bis 7.

9. Verwendung eines lichtkonvertierenden Materials gemäß einem der Ansprüche 1 bis 7 oder einer lichtkonvertierenden Mischung gemäß Anspruch 8 zur teilweisen oder vollständigen Konversion von ultraviolettem und/oder blauem Licht in Licht mit einer größeren Wellenlänge.

10. Lichtquelle, umfassend mindestens eine Primärlichtquelle und mindestens ein lichtkonvertierendes Material gemäß einem der Ansprüche 1 bis 7 oder eine lichtkonvertierende Mischung gemäß Anspruch 8.

11. Lichtquelle gemäß Anspruch 10, **dadurch gekennzeichnet, dass** das lichtkonvertierende Material oder die lichtkonvertierende Mischung direkt auf der Primärlichtquelle angeordnet ist oder auf einem Trägermaterial von der Primärlichtquelle entfernt angeordnet ist.

**12.** Verfahren zur Herstellung einer Lichtquelle gemäß Anspruch 10 oder 11, wobei das lichtkonvertierende Material oder die lichtkonvertierende Mischung in Form eines Films durch Spin-Coating oder Sprühbeschichtung oder in Form einer Folie als Laminat auf die Primärlichtquelle oder das Trägermaterial aufgebracht wird.

**13.** Beleuchtungseinheit, enthaltend mindestens eine Lichtquelle gemäß Anspruch 10 oder 11.

**Claims**

**1.** Light-converting material comprising a luminescent material being in a form of macroscopic particles and at least one type of semiconductor nanoparticles, wherein the semiconductor nanoparticles are located on the surface of the luminescent material, wherein the particles include several of the semiconductor nanoparticles, **characterized in that** the emission from the semiconductor nanoparticles is in the region of the emission from the luminescent material, wherein a maximum of a core exciton absorption band of the semiconductor nanoparticles and an emission maximum of the luminescent material are a maximum of 50 nm apart, wherein an overlap $A_{OL}$ between an emission band of the luminescent material and the core exciton absorption band of the semiconductor nanoparticles being at least 80 %, based on a total area of the core exciton excitation band $A_{ex}$ such that the following equation applies:

$$A_{OL} / A_{ex} * 100\,\% > 80\,\%,$$

and wherein the following equation applies for an emission maximum $\lambda_{em,max}$ of the semiconductor nanoparticles and an emission maximum $\lambda_{em,max}$ of the luminescent material:

$$0\ \text{nm} \leq$$
$$|\lambda_{em,max}(\text{semiconductor nanoparticles}) - \lambda_{em,max}(\text{luminescent material})| \leq 30\ \text{nm}.$$

**2.** Light-converting material according to claim 1, wherein the emission band of the semiconductor nanoparticles and the emission band of the luminescent material fully or partly overlap.

**3.** Light-converting material according to claim 1 or 2, wherein the luminescent material is a phosphor.

**4.** Light-converting material according to one or more of the claims 1 to 3, **characterized in that** the luminescent material is an inorganic phosphor activated by Eu(II), Ce(III), Mn(II), Mn(IV), Eu(III), Tb(III), Sm(III), Cr(III), Sn(II), Pb(II), Sb(III), Bi(III), Cu(I) or Ag(I), selected from the list consisting of metal oxides, silicates and halosilicates, phosphates and halophosphates, borates, haloborates and borosilicates, aluminates, gallates and alumosilicates, molybdates and tungstates, sulfates, sulfides, selenides and tellurides, nitrides and oxynitrides, SiAlONs, complex metal-oxygen compounds, halogen compounds and oxy compounds.

**5.** Light-converting material according to one or more of the claims 1 to 4, **characterized in that** the semiconductor nanoparticles comprise at least two different semiconductor materials.

**6.** Light-converting material according to claim 5, **characterized in that** the semiconductor materials are selected from group II-VI semiconductors, group III-V semiconductors, group IV-VI semiconductors, group I-III-VI$_2$ semiconductors as well as from alloys and/or combinations of these semiconductors, wherein the semiconductor materials may optionally be doped with one or more transition metals.

**7.** Light-converting material according to one or more of the claims 1 to 6, **characterized in that** the semiconductor nanoparticles are in the form of nanodots, nanorods, nanoflakes, nanotetrapods, nanodots in nanorods, nanorods in nanorods and/or nanodots in nanoflakes.

**8.** Light-converting mixture comprising one or more of the light-converting materials according to one or more of the claims 1 to 7.

**9.** Utilization of a light-converting material according to one of the claims 1 to 7 or a light-converting mixture according to claim 8 for a partial or complete conversion of ultraviolet and/or blue light into light having a longer wavelength.

10. Light source comprising at least one primary light source and at least one light-converting material according to one of the claims 1 to 7 or a light-converting mixture according to claim 8.

11. Light source according to claim 10, **characterized in that** the light-converting material or the light-converting mixture is arranged directly on the primary light source or is arranged on a support material remote from the primary light source.

12. Method for the production of a light source according to claim 10 or 11, wherein the light-converting material or the light-converting mixture is applied to the primary light source or the support material in the form of a film by spin coating or spray coating or in the form of a sheet as laminate.

13. Lighting unit containing at least one light source according to claim 10 or 11.

**Revendications**

1. Matériau capable de convertir de lumière, comportant un matériau à luminescence sous forme de particules macroscopiques et au moins un type de nanoparticules semi-conductrices, les nanoparticules semi-conductrices se trouvant à la surface du matériau à luminescence, les particules contenant plusieurs nanoparticules semi-conductrices, **caractérisé en ce que** l'émission des nanoparticules semi-conductrices se situe dans la gamme de l'émission du matériau à luminescence, l'écart entre un maximum de la bande d'absorption d'excitons nucléaires des nanoparticules semi-conductrices et un maximum d'émission du matériau à luminescence étant inférieur ou égal à 50 nm, un chevauchement $A_{OL}$ entre la bande d'émission du matériau à luminescence et la bande d'absorption d'excitons nucléaires des nanoparticules semi-conductrices étant supérieur ou égal à 80 %, par rapport à la superficie totale de la bande d'excitation d'excitons nucléaires $A_{ex}$, permettant ainsi d'établir l'équation suivante :

$$A_{OL} \; / \; A_{ex} \; * \; 100 \; \% \; > \; 80 \; \%$$

le maximum d'émission $\lambda_{em,max}$ des nanoparticules semi-conductrices et le maximum d'émission $\lambda_{em,max}$ du matériau à luminescence répondant en outre à l'équation suivante :

0 nm $\leq$ |$\lambda_{em,max}$ (nanoparticules semi-conductrices) - $\lambda_{em,max}$ (matériau à luminescence) | $\leq$ 30 nm.

2. Matériau capable de convertir la lumière selon la revendication 1, la bande d'émission des nanoparticules et la bande d'émission du matériau à luminescence se chevauchant en totalité ou en partie.

3. Matériau capable de convertir la lumière selon les revendications 1 ou 2, le matériau à luminescence étant un phosphore.

4. Matériau capable de convertir la lumière selon l'une ou plusieurs des revendications 1 à 3, **caractérisé en ce que** le matériau à luminescence est un phosphore inorganique activé par Eu (II), Ce(III), Mn (II), Mn(IV), Eu(III), Tb(III), Sm(III), Cr(III); Sn(II), Pb(II), Sb(III), Bi(III), Cu(I) ou Ag(I), choisi dans la liste constituée d'oxydes métalliques, silicates et halosilicates, phosphates et halophosphates, borates, haloborates et borosilicates, aluminates, gallates et aluminosilicates, molybdates et tungstates, sulfates, sulfures, sélénures et tellurures, nitrures et oxynitrures, composés de type Si-AlO-N, composés complexes de type métal-oxygène, composés halogénés et de composés oxy.

5. Matériau capable de convertir la lumière selon l'une ou plusieurs des revendications 1 à 4, **caractérisé en ce que** les nanoparticules semi-conductrices comprennent au moins deux matériaux semi-conducteurs différents.

6. Matériau capable de convertir la lumière selon la revendication 5, **caractérisé en ce que** les matériaux semi-conducteurs sont choisis parmi les semi-conducteurs de groupe II-IV, les semiconducteurs de groupe III-V, les semi-conducteurs de groupe IV-VI, les semi-conducteurs de groupe I-III-VI$_2$ ainsi que parmi les alliages et/ou les combinaisons desdits semi-conducteurs, les matériaux semi-conducteurs pouvant optionnellement être dotés avec un ou plusieurs métaux de transition.

**7.** Matériau capable de convertir la lumière selon l'une ou plusieurs des revendications 1 à 6, **caractérisé en ce que** les nanoparticules semi-conductrices se présentent sous forme de nanopoints, nanobâtonnets, nanoplaquettes, nanotétrapodes, nanopoints dans des nanobâtonnets, nanobâtonnets dans des nanobâtonnets et/ou de nanopoints dans des nanoplaquettes.

**8.** Mélange capable de convertir la lumière, comprenant un ou plusieurs des matériaux capables de convertir la lumière selon l'une ou plusieurs des revendications 1 à 7.

**9.** Utilisation d'un matériau capable de convertir la lumière selon l'une des revendications 1 à 7 ou d'un mélange capable de convertir la lumière selon la revendication 8 pour partiellement ou totalement convertir de la lumière ultra-violette ou bleue en une lumière ayant une plus grande longueur d'onde.

**10.** Source de lumière, comprenant au moins une source de lumière primaire et au moins un matériau capable de convertir la lumière selon l'une des revendications 1 à 7 ou un mélange capable de convertir la lumière selon la revendication 8.

**11.** Source de lumière selon la revendication 10, **caractérisée en ce que** le matériau capable de convertir la lumière ou le mélange capable de convertir la lumière est disposé directement sur la source de lumière primaire ou disposé sur un matériau support, à distance de la source de lumière primaire.

**12.** Procédé de fabrication d'une source de lumière selon les revendications 10 ou 11, consistant à appliquer le matériau capable de convertir la lumière ou le mélange capable de convertir la lumière sur la source de lumière primaire ou sur le matériau support, sous forme d'un film par enduction centrifuge ou dépôt par pulvérisation ou bien sous forme d'une feuille en réalisant un produit de lamination.

**13.** Unité d'éclairage, contenant au moins une source de lumière selon les revendications 10 ou 11.

Figur 1

Figur 2

## Figur 3

## Figur 4

Figur 5

Figur 6

Figur 7

Figur 8

Figur 9

Figur 10

# EP 3 729 520 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 7102152 B2
- US 7495383 B2
- US 7318651 B2
- US 20130341590 A1
- WO 2017004145 A1
- US 20150014728 A1
- US 20050135079 A1
- WO 2005075339 A
- WO 2006134599 A
- EP 2528989 B1

- US 8062421 B2
- WO 2010095140 A3
- WO 2011092646 A2
- WO 2014140936 A
- JP 4304290 A
- WO 9110715 A
- WO 9927033 A
- US 20070298250 A
- WO 2009065480 A
- WO 2010075908 A

### In der Beschreibung aufgeführte Nicht-Patentliteratur

- **Z. LIU et al.** Status and prospects for phosphor-based white LED Packaging. *Xiaobing Front. Optoelectron. China*, 2009, vol. 2 (2), 119-140
- **JOSEPH R. LAKOWICZ**. Principles of Fluorescence Spectroscopy. Kluwer Academic / Plenum Publishers, 1999, 367-443
- **JAN ZIEGLER et al.** Silica-Coated InP/ZnS Nanocrystals as Converter Material in White LEDs. *Advanced Materials*, 13 October 2008, vol. 20 (21), 4068-4073

- Silica-Coated InP/ZnS Nanocrystals as Converter Material in White LEDs. **DER ARTIKEL VON ZIEGLER, J. et al.** Advanced Materials. Wiley-VCH, 2008, vol. 20, 4068-4073
- **M. J. ANC** ; **N. L. PICKETT et al.** *ECS Journal of Solid State Science and Technology*, 2013, vol. 2 (2), R3071-R3082